# FASCICULE DE BREVET EUROPEEN

(11) **EP 3 465 050 B1**
(45) Date de publication et mention de la délivrance du brevet: **16.12.2020**
(21) Numéro de dépôt: 17726282.1
(22) Date de dépôt: 24.05.2017
(51) Int. Cl.: B60H 1/00, B64D 13/06, F28D 15/00, F28D 15/02, F28D 20/00, F28D 20/02, F28F 27/00, H05K 7/20

(54) **PROCÉDÉ ET DISPOSITIF DE REFROIDISSEMENT D'AU MOINS UNE CHARGE CHAUDE À BORD D'UN VÉHICULE TEL QU'UN AÉRONEF À BOUCLE FLUIDE PARTIELLEMENT RÉVERSIBLE**
VERFAHREN UND VORRICHTUNG ZUM KÜHLEN MINDESTENS EINER WÄRMEQUELLE AN BORD EINES FAHRZEUGS, Z.B. FLUGZEUGS, MIT EINEM TEILWEISE REVERSIBLEN FLUIDKREISLAUF
METHOD AND DEVICE FOR COOLING AT LEAST ONE HEAT SOURCE OF A VEHICLE LIKE AN AIRCRAFT WITH A PARTIAL REVERSIBLE CYCLE

(30) Priorité: 30.05.2016 FR 1600875
(43) Date de publication de la demande: 10.04.2019
(73) Titulaire: Liebherr-Aerospace Toulouse SAS, 31200 Toulouse (FR)
(72) Inventeur: GALZIN, Guillaume, 31200 TOULOUSE (FR); JUVIN, Olivier, 31400 TOULOUSE (FR)
(74) Mandataire: BARRE LAFORGUE
(86) Numéro de dépôt international: PCT/EP2017/062649
(87) Numéro de publication internationale: WO 2017/207404

(56) Documents cités:
- WO-A1-2017/029459
- DE-A1- 10 140 630
- DE-A1-102008 007 560
- US-A- 5 497 629

## Description

L'invention concerne un procédé et un dispositif de refroidissement d'au moins une charge chaude à bord d'un véhicule tel qu'un aéronef, comportant une boucle fluide de circulation d'un fluide caloporteur. Le document WO20178029459A1, qui est publié après la date de dépôt de cette demande mais avec une priorité antérieure, décrit un procédé et un dispositif similaire Le document DE102008007560A1 divulgue un procédé selon la préambule de la revendication 1 et un dispositif selon la préambule de la revendication 7.

Dans tout le texte, on adopte la terminologie suivante :
- fluide caloporteur : tout fluide susceptible de transporter de l'énergie thermique (calories ou frigories) et d'échanger de l'énergie thermique (calories ou frigories) avec un milieu extérieur ;
- échangeur de chaleur : tout dispositif permettant de transférer de l'énergie thermique (calories ou frigories) entre un fluide caloporteur et un autre composant par conduction et/ou convection et/ou rayonnement par contact du dispositif avec le fluide caloporteur et avec ledit autre composant ;
- dispositif d'échange thermique : tout dispositif permettant de transférer de l'énergie thermique (calories ou frigories) entre deux composants ; un dispositif d'échange de chaleur peut comporter un ou plusieurs échangeur(s) de chaleur, en parallèle ou en série, éventuellement avec une ou plusieurs boucle(s) fluide, en parallèle ou en série,
- véhicule : tout type d'engin mobile destiné à transporter une charge utile, et en particulier pouvant être choisi parmi les aéronefs (avions de transport de passagers, les avions de transport de marchandises, avions de combat, hélicoptères, drones...), les engins spatiaux, les véhicules de transport terrestre (véhicules routiers ou sur rails...), les véhicules de transport aquatique ou maritime (navires, sous-marins...).

On connaît déjà divers systèmes de refroidissement de charges chaudes telles que des circuits électriques et/ou électroniques d'un véhicule, comprenant une boucle fluide diphasique (à cycle vapeur) comportant un ou plusieurs compresseurs, condenseurs, vannes de détente, évaporateurs, et des conduites de circulation d'un fluide caloporteur.

On sait aussi qu'il est possible d'utiliser l'air extérieur au véhicule à titre de source froide pour le refroidissement de charges chaudes à bord d'un véhicule.

Il a par ailleurs également été proposé d'utiliser un réservoir de carburant, ou d'eau, ou d'un autre fluide embarqué, voire même une boucle de circulation d'un tel fluide embarqué, à titre d'accumulateur thermique formant une source froide embarquée. Néanmoins, le problème se pose alors de contrôler la température de cet accumulateur thermique, notamment dans le cas d'un réservoir de carburant. Pour ce faire, il est nécessaire de prévoir un dispositif spécifique de refroidissement de l'accumulateur thermique, par exemple un échangeur permettant de refroidir l'accumulateur thermique à partir de l'air extérieur au véhicule, directement ou par l'intermédiaire d'une boucle fluide de circulation d'un autre fluide caloporteur. Un tel dispositif spécifique de refroidissement de l'accumulateur thermique est cependant lourd, encombrant et coûteux, ce qui peut même remettre en cause l'intérêt que peut avoir l'utilisation de l'accumulateur thermique à titre de source froide pour le refroidissement de charges chaudes à bord d'un véhicule tel qu'un aéronef. En outre, il ne permet pas de réaliser un refroidissement efficace de l'accumulateur thermique lorsque le véhicule est à l'arrêt.

Dans ce contexte, l'invention vise à optimiser l'utilisation d'un accumulateur thermique embarqué à titre de source froide pour le refroidissement d'au moins une charge chaude à bord d'un véhicule tel qu'un aéronef.

L'invention vise en particulier à proposer un procédé et un dispositif de refroidissement de masse réduite, d'encombrement réduit et de consommation énergétique réduite.

L'invention vise également à atteindre ces objectifs à moindre coût.

L'invention vise plus particulièrement à permettre l'utilisation combinée et optimisée d'air extérieur au véhicule et d'au moins un accumulateur thermique embarqué pour le refroidissement d'au moins une charge chaude à bord d'un véhicule tel qu'un aéronef.

L'invention vise à proposer un procédé et un dispositif de refroidissement de toute charge chaude à bord d'un véhicule. Elle vise plus particulièrement à proposer un procédé et un dispositif de refroidissement d'au moins une charge chaude choisie dans le groupe formé des dispositifs électriques (par exemple une source de puissance électrique d'alimentation d'un réseau électrique à bord du véhicule) et/ou électroniques et/ou informatiques, de l'air de compartiments à refroidir, de l'air de cabine, des volumes de liquide (notamment choisis parmi les volumes de carburant, les volumes d'eau et les volumes de liquides caloporteurs distincts de l'eau et du carburant). Elle vise en particulier à proposer un procédé et un dispositif de refroidissement d'au moins une charge chaude formée d'un dispositif électrique et/ou électronique, notamment une source de puissance électrique d'alimentation d'un réseau électrique à bord d'un véhicule.

L'invention concerne donc un procédé de refroidissement d'au moins une charge chaude à bord d'un véhicule tel qu'un aéronef comportant une boucle fluide de circulation d'un fluide caloporteur diphasique selon la revendication 1, dans lequel :
- pour chaque charge chaude à refroidir, un débit dudit fluide caloporteur, dit débit de fluide caloporteur froid, est introduit dans un échangeur de chaleur, dit premier échangeur de chaleur, d'un premier dispositif d'échange thermique associé à la charge chaude de façon à transférer des calories de cette dernière vers le fluide caloporteur, refroidir la charge chaude et produire un débit dudit fluide caloporteur, dit débit de fluide caloporteur chaud, à une température supérieure à celle dudit débit de fluide caloporteur froid,
- au moins une partie dudit débit de fluide caloporteur chaud issu d'au moins un premier échangeur de chaleur est introduite dans au moins un échangeur de chaleur, dit deuxième échangeur de chaleur, d'un deuxième dispositif d'échange thermique agencé pour pouvoir la refroidir par de l'air extérieur au véhicule,

- un débit dudit fluide caloporteur est introduit dans au moins un échangeur de chaleur, dit troisième échangeur de chaleur, d'un troisième dispositif d'échange thermique agencé pour pouvoir échanger un flux thermique entre ce débit dudit fluide caloporteur et au moins un accumulateur thermique, distinct dudit fluide caloporteur, embarqué à bord du véhicule,
- lorsque des critères de besoin de refroidissement sont remplis, au moins un tel -notamment chaque- troisième échangeur de chaleur est alimenté selon un mode de circulation, dit mode direct, dans lequel il reçoit, sur une première bouche de ce troisième échangeur de chaleur, au moins une partie dudit débit de fluide caloporteur chaud issu d'au moins un -notamment de chaque- premier échangeur de chaleur, ledit troisième dispositif d'échange thermique correspondant (c'est-à-dire comprenant ce troisième échangeur de chaleur) transférant des calories depuis ce fluide caloporteur chaud vers l'accumulateur thermique de façon à refroidir ledit fluide caloporteur, le fluide caloporteur ainsi refroidi étant délivré par une deuxième bouche du troisième échangeur de chaleur,
- lorsque lesdits critères de besoin de refroidissement ne sont pas remplis, au moins un tel -notamment chaque- troisième échangeur de chaleur est alimenté selon un mode de circulation, dit mode inverse, dans lequel il reçoit, sur ladite deuxième bouche de ce troisième échangeur de chaleur, un débit dudit fluide caloporteur -notamment à une température inférieure à la température de l'accumulateur thermique- et le troisième dispositif d'échange thermique correspondant (c'est-à-dire comprenant ce troisième échangeur de chaleur) transfère des calories depuis au moins un accumulateur thermique vers ce fluide caloporteur de façon à refroidir cet accumulateur thermique, et le fluide caloporteur ainsi réchauffé sort de ce troisième échangeur de chaleur par ladite première bouche de ce troisième échangeur de chaleur.

L'invention s'étend également à un dispositif de refroidissement pour la mise en œuvre d'un procédé de refroidissement selon l'invention. L'invention concerne donc également un dispositif selon la revendication 7, qui est un dispositif de refroidissement d'au moins une charge chaude à bord d'un véhicule tel qu'un aéronef comportant une boucle fluide diphasique de circulation d'un fluide caloporteur comprenant :
- pour chaque charge chaude à refroidir, un premier dispositif d'échange thermique associé à la charge chaude de façon à pouvoir transférer des calories de cette dernière vers un débit dudit fluide caloporteur, dit débit de fluide caloporteur froid, introduit dans un échangeur de chaleur, dit premier échangeur de chaleur, de ce premier dispositif d'échange thermique, refroidir la charge chaude et produire un débit dudit fluide caloporteur, dit débit de fluide caloporteur chaud, à une température supérieure à celle dudit débit de fluide caloporteur froid,
- au moins un deuxième dispositif d'échange thermique agencé pour pouvoir refroidir par de l'air extérieur au véhicule au moins une partie dudit débit de fluide caloporteur chaud issu d'au moins un premier échangeur de chaleur et introduite dans un échangeur de chaleur, dit deuxième échangeur de chaleur, de ce deuxième dispositif d'échange thermique,
- au moins un troisième dispositif d'échange thermique agencé pour pouvoir échanger un flux thermique entre au moins un accumulateur thermique, distinct dudit fluide caloporteur, embarqué à bord du véhicule et un débit dudit fluide caloporteur introduit dans un échangeur de chaleur, dit troisième échangeur de chaleur, de ce troisième dispositif d'échange thermique,
- pour chaque troisième échangeur de chaleur, un circuit, dit circuit d'inversion, comprenant un dispositif d'inversion commandé comportant au moins une vanne commandée, ledit circuit d'inversion et le dispositif d'inversion commandé étant agencés pour pouvoir faire circuler ledit fluide caloporteur dans le troisième échangeur de chaleur selon un mode de circulation choisi parmi :
   ∘ un mode direct dans lequel le troisième échangeur de chaleur reçoit, sur une première bouche de ce troisième échangeur de chaleur, au moins une partie dudit débit de fluide caloporteur chaud issu d'au moins un premier échangeur de chaleur -notamment à une température supérieure à celle de l'accumulateur thermique-et le troisième dispositif d'échange thermique correspondant transfère des calories depuis ce fluide caloporteur chaud vers l'accumulateur thermique de façon à refroidir ce fluide caloporteur chaud, le fluide caloporteur ainsi refroidi étant délivré par une deuxième bouche du troisième échangeur de chaleur, et
   ∘ un mode inverse dans lequel le troisième échangeur de chaleur reçoit, sur la deuxième bouche de ce troisième échangeur de chaleur, un débit dudit fluide caloporteur -notamment un débit de fluide caloporteur à une température inférieure à la température de l'accumulateur thermique- et le troisième dispositif d'échange thermique correspondant transfère des calories depuis au moins un accumulateur thermique vers ce fluide caloporteur de façon à refroidir cet accumulateur thermique, le fluide caloporteur ainsi réchauffé sort de ce troisième échangeur de chaleur par ladite première bouche de ce troisième échangeur de chaleur.

Dans un procédé et un dispositif de refroidissement selon l'invention, la boucle fluide est donc partiellement réversible, seul le fonctionnement de chaque troisième échangeur de chaleur et le circuit d'inversion correspondant étant réversibles. En particulier, il est à noter que l'intégralité de la boucle fluide selon l'invention n'a pas à être réversible, contrairement à certains systèmes connus de gestion thermique utilisés dans des installations fixes, notamment pour le chauffage ou la climatisation de locaux. En effet, ladite boucle fluide permet de refroidir chaque charge chaude aussi bien en mode direct qu'en mode inverse.

Dans un procédé et un dispositif de refroidissement selon l'invention, chaque premier dispositif d'échange thermique peut être constitué uniquement d'un simple échangeur, c'est-à-dire d'un premier échangeur de chaleur. Rien n'empêche en variante de prévoir au moins un premier dispositif d'échange thermique comportant plusieurs échangeurs de chaleur, en série ou en parallèle, et/ou une ou plusieurs boucle(s) fluide (monophasique ou diphasique) intermédiaire(s).

Dans un procédé et un dispositif de refroidissement selon l'invention, chaque deuxième dispositif d'échange thermique peut être constitué uniquement d'un simple échangeur, c'est-à-dire d'un deuxième échangeur de chaleur. Rien n'empêche en variante de prévoir au moins un deuxième dispositif d'échange thermique comportant plusieurs échangeurs de chaleur, en série ou en parallèle, et/ou une ou plusieurs boucle(s) fluide(s) diphasique intermédiaire(s).

Dans un procédé et un dispositif de refroidissement selon l'invention, chaque troisième dispositif d'échange thermique peut être constitué uniquement d'un simple échangeur, c'est-à-dire d'un troisième échangeur de chaleur. Rien n'empêche en variante de prévoir au moins un troisième dispositif d'échange thermique comportant plusieurs échangeurs de chaleur, en série ou en parallèle, et/ou une ou plusieurs boucle(s) fluide(s) diphasique intermédiaire(s).

Un exemple qui ne forme pas d'un part de l'invention s'applique avec une boucle fluide monophasique, c'est-à-dire comprenant un fluide caloporteur dont l'état physique ne change pas au cours du cycle thermodynamique mis en œuvre lors de la circulation dans la boucle fluide. Ce fluide caloporteur monophasique peut être un liquide ou une composition gazeuse.

L'invention s'applique au cas d'une boucle fluide diphasique c'est-à-dire comprenant un fluide caloporteur susceptible de se présenter au moins partiellement à l'état liquide et au moins partiellement à l'état vapeur, la boucle fluide étant adaptée pour que l'état physique du fluide caloporteur change au cours du cycle thermodynamique réalisé lors de la circulation dans la boucle fluide. Un fluide caloporteur diphasique pouvant être utilisé dans un procédé et un dispositif de refroidissement selon l'invention peut être choisi par exemple dans le groupe formé des fluides réfrigérants diphasiques (tels que les hydrofluorocarbures (en particulier le R245fa, le R134a, le R236fa) et les hydrofluoroléfines (en particulier le HFO1234ze, le HFO1234yf et le HFO2345zde), le dioxyde de carbone, l'air, et les liquides monophasiques (tels que les EGW (compositions aqueuses d'éthylène glycol), les PGW (compositions aqueuses de propylène glycol), les coolanol ®, et les polyalphaoléfines PAO).

Par ailleurs, le débit dudit fluide caloporteur alimentant un troisième échangeur de chaleur en mode inverse doit être choisi pour présenter une température inférieure à celle de l'accumulateur thermique de façon à pouvoir refroidir ce dernier. Il peut s'agir en particulier d'au moins une partie d'un débit de fluide caloporteur froid dont une autre partie forme ledit débit de fluide caloporteur froidintroduit dans un premier échangeur de chaleur.

Dans certains modes de réalisation avantageux en mode inverse, chaque troisième échangeur de chaleur reçoit un débit de fluide caloporteur, dit débit de fluide caloporteur refroidi, issu d'un réservoir de fluide caloporteur par l'intermédiaire d'un dispositif de détente (vanne de détente, orifice de détente, tube capillaire, turbine...). Ainsi, dans ces modes de réalisation, un dispositif selon l'invention comporte un réservoir de fluide caloporteur et au moins un dispositif de détente interposé entre le réservoir de fluide caloporteur et un troisième échangeur de chaleur et agencé pour délivrer, en mode inverse, à ce troisième échangeur de chaleur un débit de fluide caloporteur, dit débit de fluide caloporteur refroidi, à une température inférieure à celle de chaque accumulateur thermique associé à ce troisième échangeur de chaleur.

Par ailleurs, dans un procédé et un dispositif de refroidissement selon l'invention, lesdits critères de besoin de refroidissement peuvent être choisis parmi différents critères, selon les besoins et les applications. Au moins un troisième échangeur de chaleur est alimenté en mode inverse lorsqu'il n'est pas nécessaire d'utiliser ce troisième échangeur de chaleur pour refroidir le fluide caloporteur, les besoins de refroidissement de chaque charge chaude à refroidir étant suffisamment faibles pour autoriser l'utilisation de ce troisième échangeur de chaleur pour refroidir chaque accumulateur thermique associé au troisième dispositif thermique comportant ce troisième échangeur de chaleur.

Le passage du mode direct au mode inverse d'alimentation de chaque troisième échangeur de chaleur peut être effectué au moins pour partie manuellement, par exemple sur commande d'un opérateur. Néanmoins, de préférence, ce passage est effectué entièrement automatiquement, sur commande d'une unité de commande du dispositif de refroidissement. Ainsi, un dispositif de refroidissement selon l'invention comporte avantageusement une unité de commande adaptée pour pouvoir commander au moins un -notamment chaque- dispositif d'inversion :
- en mode direct lorsque des critères de besoin de refroidissement sont remplis,
- en mode inverse lorsque lesdits critères de besoin de refroidissement ne sont pas remplis.

Dans certains modes de réalisation avantageux d'un procédé selon l'invention :
- lesdits critères de besoin de refroidissement comprennent au moins un critère, dit critère de température, selon lequel la température d'au moins une charge chaude est supérieure à une température maximale admissible,
- la température de chaque charge chaude pour laquelle au moins un critère de température est défini est mesurée,
- au moins un tel -notamment chaque- troisième échangeur de chaleur est alimenté :
   ∘ en mode direct lorsque la température mesurée de chaque charge chaude remplit chaque critère de température,
   ∘ en mode inverse au moins lorsque la température mesurée de chaque charge chaude ne remplit pas chaque critère de température.

Dans ces modes de réalisation, l'unité de commande d'un dispositif selon l'invention est aussi avantageusement adaptée pour :
- recevoir des signaux de mesure de température de chaque charge chaude pour laquelle au moins un critère de température est défini,
- vérifier si chaque critère de température est rempli,
- commander au moins un tel -notamment chaque- dispositif d'inversion :
   ∘ en mode direct lorsque la température mesurée de chaque charge chaude remplit chaque critère de température,
   ∘ en mode inverse au moins lorsque la température mesurée de chaque charge chaude ne remplit pas chaque critère de température.

Au moins un critère de température est une température d'au moins une -notamment de chaque- charge chaude supérieure à une température maximale admissible. En effet, si la température d'une charge chaude est supérieure à une telle température maximale admissible, cela signifie que les besoins de refroidissement sont relativement importants, de sorte qu'au moins un troisième échangeur de chaleur -notamment si nécessaire chaque troisième échangeur de chaleur-est alimenté en mode direct de façon que le dispositif de refroidissement fournisse une capacité de refroidissement plus importante -notamment maximale-. Au contraire, si la température de chaque charge chaude n'est pas supérieure à une telle température maximale admissible, les besoins de refroidissement sont moins importants, et il est possible de ne pas utiliser au moins un troisième échangeur de chaleur en mode direct pour le refroidissement, et de l'alimenter en mode inverse pour refroidir au contraire ce troisième échangeur de chaleur. Ladite température maximale admissible qui peut être prédéterminée, ou au contraire déterminée dynamiquement, notamment en temps réel, par une unité logique. Ladite température maximale admissible peut être déterminée pour chaque charge chaude à refroidir, en fonction des besoins en refroidissement de cette charge chaude. Elle peut donc varier d'une charge chaude à l'autre.

En variante ou en combinaison, la vitesse d'un compresseur rotatif de la boucle fluide peut être utilisée à titre de critère de besoin de refroidissement. En effet, dans certains modes de réalisation d'un dispositif de refroidissement selon l'invention, la boucle fluide comprend un compresseur rotatif dont la vitesse de rotation est asservie par l'unité de commande de façon à contrôler la température de chaque charge chaude. Or, lorsque la vitesse du compresseur est inférieure à sa vitesse maximale, cela signifie qu'il reste une possibilité d'utiliser une partie de débit du fluide caloporteur de la boucle fluide pour le refroidissement d'un accumulateur thermique. Ainsi, dans ces modes de réalisation, l'unité de commande est adaptée pour commander au moins un tel -notamment chaque- dispositif d'inversion :
- en mode direct lorsque la vitesse d'un compresseur de la boucle fluide est supérieure à une valeur prédéterminée,
- en mode inverse au moins lorsque la vitesse du compresseur de la boucle fluide est inférieure à ladite valeur prédéterminée.

Il est également à noter qu'il est possible d'envisager toute combinaison logique de sélection de l'alimentation de chaque troisième échangeur de chaleur, selon les besoins de refroidissement, en fonction des architectures et des combinaisons des différents échangeurs de chaleur et des applications. En particulier, la sélection d'une alimentation en mode direct d'un troisième échangeur de chaleur, ou d'un ensemble prédéterminé de troisièmes échangeurs de chaleur, ou de l'intégralité des troisièmes échangeurs de chaleur, peut être déclenchée si la température d'une seule charge chaude dépasse une valeur seuil prédéterminée, ou si la température d'un ensemble prédéterminé de charges chaudes dépasse une valeur seuil prédéterminée pour chacune de ces charges chaudes, ou si la température de l'intégralité des charges chaudes à refroidir dépasse une valeur seuil prédéterminée pour chacune de ces charges chaudes. De même, la sélection d'une alimentation en mode inverse d'un troisième échangeur de chaleur, ou d'un ensemble prédéterminé de troisièmes échangeurs de chaleur, ou de l'intégralité des troisièmes échangeurs de chaleur, peut être déclenchée si la température d'une seule charge chaude est inférieure à une valeur seuil prédéterminée, ou si la température d'un ensemble prédéterminé de charges chaudes est inférieure à une valeur seuil prédéterminée pour chacune de ces charges chaudes, ou si la température de l'intégralité des charges chaudes à refroidir est inférieure à une valeur seuil prédéterminée pour chacune de ces charges chaudes.

Également, d'autres critères que la température d'au moins une charge chaude représentatifs des besoins de refroidissement peuvent être utilisés, en variante ou en combinaison, pour sélectionner l'alimentation en mode direct ou en mode inverse de chaque troisième échangeur de chaleur : par exemple l'intensité d'un courant électrique consommé par au moins une charge chaude ; un paramètre de fonctionnement d'au moins une charge chaude représentatif du fait que cette dernière présente des besoins de refroidissement plus important ; la température de l'air extérieur ; le débit disponible d'air extérieur ; la pression de condensation ; la température de l'accumulateur thermique...

De même, la logique de sélection d'alimentation en mode direct ou en mode inverse de chaque troisième échangeur de chaleur peut faire l'objet de nombreuses variantes de réalisation et peut être plus ou moins complexe : il peut s'agir d'un asservissement en boucle fermée comprenant une ou plusieurs boucle(s) pour réaliser une régulation appropriée, proportionnelle et/ou intégrale et/ou dérivée ou autre.

L'invention s'applique à toutes sortes d'architectures et de combinaisons d'au moins un premier dispositif d'échange thermique comportant au moins un premier échangeur de chaleur, d'au moins un deuxième dispositif d'échange thermique comportant au moins un deuxième échangeur de chaleur et d'au moins un troisième dispositif d'échange thermique associé à au moins un accumulateur thermique embarqué et comportant au moins un troisième échangeur de chaleur. Par exemple, un même troisième dispositif d'échange thermique est associé à un accumulateur thermique ou à plusieurs accumulateurs thermiques ; plusieurs troisièmes dispositifs d'échange thermique sont associés à un même accumulateur thermique, ou à plusieurs accumulateurs thermiques ; un même premier échangeur de chaleur est associé à une seule charge chaude ou à une pluralité de charges chaudes distinctes ; la boucle fluide peut comporter un seul premier échangeur de chaleur ; au contraire plusieurs premiers échangeurs de chaleur peuvent être incorporés dans la boucle fluide, en parallèle ou en série ; la boucle fluide peut comporter un seul deuxième échangeur de chaleur ; au contraire plusieurs deuxièmes échangeurs de chaleur peuvent être incorporés dans la boucle fluide, en parallèle ou en série etc.

Dans certains modes de réalisation possible d'un procédé selon l'invention pour chaque premier échangeur de chaleur associé à une charge chaude, un unique troisième échangeur de chaleur est agencé pour pouvoir recevoir, en mode direct, une partie du débit de fluide caloporteur chaud issu de ce premier échangeur de chaleur. En variante ou en combinaison, pour chaque deuxième échangeur de chaleur, un unique troisième échangeur de chaleur est agencé pour pouvoir recevoir, en mode direct, au moins une partie dudit débit de fluide caloporteur chaud issu d'au moins un premier échangeur de chaleur et dont au moins une partie est délivrée à ce deuxième échangeur de chaleur.

Par ailleurs, le circuit d'inversion et le dispositif d'inversion commandé de chaque troisième échangeur de chaleur peuvent faire l'objet de très nombreuses variantes différentes de réalisation dès lors qu'ils permettent la sélection du mode d'alimentation du troisième échangeur de chaleur en mode direct ou en mode inverse.

Dans certains modes de réalisation possibles selon l'invention, au moins un dispositif d'inversion commandé -notamment chaque dispositif d'inversion commandé- d'au moins un troisième échangeur de chaleur comporte une vanne trois voies commandée présentant :
- une sortie reliée à une conduite à l'aval d'au moins un premier échangeur -notamment à une conduite de sortie d'au moins un premier échangeur et/ou à l'amont d'au moins un étage d'un compresseur de la boucle fluide relié à cette conduite de sortie-,
- une entrée reliée à une conduite reliée à un deuxième échangeur de chaleur -notamment à une conduite d'entrée d'un deuxième échangeur de chaleur agencé en parrallèle au troisième échangeur de chaleur, ou à une conduite de sortie d'un deuxième échangeur de chaleur agencé en série à l'amont du troisième échangeur de chaleur-,
- une entrée/sortie reliée à une première bouche du troisième échangeur de chaleur,
et l'unité de commande est reliée à la vanne trois voies et adaptée pour :
- en mode direct relier l'entrée de la vanne trois voies à son entrée/sortie qui fait office de sortie pour un débit dudit fluide caloporteur prélevé de la conduite d'entrée du deuxième échangeur de chaleur,
- en mode inverse relier l'entrée/sortie de la vanne trois voies à sa sortie, l'entrée/sortie faisant office d'entrée pour un débit dudit fluide caloporteur issu du troisième échangeur de chaleur, ledit fluide caloporteur issu de la sortie de la vanne trois voies étant mélangé audit fluide caloporteur de ladite conduite de sortie.

Rien n'empêche cependant de prévoir toute autre archirtecture de réalisation d'un tel dispositif d'inversion, ladite vanne trois voies pouvant être par exemple remplacée par deux vannes deux voies commandées, une dans chaque conduite reliée à la première bouche du troisième échangeur de chaleur. Par ailleurs la vanne trois voies (ou lesdites vannes deux voies) du dispositif d'inversion n'ont pas à être des vannes proportionnelles, et peuvent être des électrovannes tout ou rien.

En outre, avantageusement et selon l'invention, ladite deuxième bouche du troisième échangeur est reliée en mode direct à une conduite de sortie d'au moins un tel deuxième échangeur de chaleur, ledit fluide caloporteur issu de cette deuxième bouche du troisième échangeur étant mélangé audit fluide caloporteur de cette conduite de sortie refroidi par le deuxième dispositif d'échange thermique.

En mode inverse ladite deuxième bouche du troisième échangeur reçoit au moins une partie dudit débit de fluide caloporteur froid introduit dans un premier échangeur de chaleur. En particulier, ladite deuxième bouche du troisième échangeur est reliée à un dispositif de détente d'un débit dudit fluide caloporteur - notamment à un dispositif de détente (vanne de détente, orifice de détente, tube capillaire, turbine...) adapté pour délivrer le fluide caloporteur à une température inférieure à la température de l'accumulateur thermique-.

En outre, en mode inverse la première bouche de ce troisième échangeur de chaleur est reliée à une conduite reliée à la sortie du premier échangeur de chaleur de façon à mélanger le débit de fluide caloporteur réchauffé par le troisième échangeur de chaleur avec le débit de fluide caloporteur réchauffé par ce premier échangeur de chaleur. Le débit cumulé de fluide caloporteur réchauffé ainsi formé par ce mélange est introduit à l'entrée du deuxième dispositif d'échange thermique - notamment à l'entrée d'un deuxième échangeur de chaleur- pour être refroidi par l'air extérieur. Ainsi, en mode inverse, le débit de fluide caloporteur réchauffé par le troisième échangeur de chaleur, qui permet de refroidir l'accumulateur thermique, est refroidi par le deuxième dispositif d'échange thermique.

Dans certains modes de réalisation simplifiés d'un procédé et d'un dispositif de refroidissement selon l'invention, la boucle fluide comprend un unique deuxième échangeur de chaleur et un unique troisième échangeur de chaleur agencés en parallèle entre un premier nœud de la boucle fluide recevant ledit débit de fluide caloporteur chaud issu de chaque charge chaude à refroidir -notamment un nœud à l'aval d'un compresseur recevant ledit débit de fluide caloporteur chaud issu de chaque premier échangeur de chaleur et délivrant du fluide caloporteur chaud comprimé sur ce nœud- et un deuxième nœud de la boucle fluide recevant le débit dudit fluide caloporteur refroidi délivré par le deuxième échangeur de chaleur. Le troisième échangeur de chaleur peut être associé à un unique accumulateur thermique embarqué, par exemple formé d'un réservoir de carburant. Le premier nœud de la boucle fluide est relié à une entrée d'une vanne trois voies commandée dont une entrée/sortie est reliée à une première bouche du troisième échangeur de chaleur. Le circuit d'inversion comprend une conduite reliant une sortie de la vanne trois voies à un autre nœud de la boucle fluide sur une conduite recevant ledit débit de fluide caloporteur chaud de chaque premier échangeur de chaleur de façon à mélanger le débit dudit fluide caloporteur sortant du troisième échangeur de chaleur en mode inverse audit débit de fluide caloporteur chaud. Le circuit d'inversion comprend également une conduite reliant, en mode inverse, un dispositif de détente -notamment une vanne de détente commandée- à une deuxième bouche du troisième échangeur de chaleur, ce dispositif de détente étant lui-même alimenté en fluide caloporteur à partir d'un réservoir de fluide caloporteur. Le deuxième nœud de la boucle fluide est relié à une entrée du réservoir de fluide caloporteur. Le deuxième nœud est relié à la deuxième bouche du troisième échangeur de chaleur par l'intermédiaire d'une soupape (ou d'une vanne commandée) agencée pour interdire la circulation du fluide caloporteur depuis le deuxième nœud vers la deuxième bouche du troisième échangeur de chaleur lorsque ladite vanne de détente est commandée en mode inverse.

Dans un procédé et un dispositif selon l'invention, chaque accumulateur thermique associé à un troisième dispositif d'échange thermique peut être choisi parmi tout accumulateur thermique embarqué à bord du véhicule, distinct dudit fluide caloporteur de la boucle fluide, et présentant une inertie thermique suffisante. En particulier, dans certains modes de réalisation, chaque accumulateur thermique associé à un troisième dispositif d'échange thermique est choisi dans le groupe formé des réservoirs de liquide, des réservoirs de gaz, des réservoirs de matériau à changement de phase (liquide/gaz, ou solide/liquide, ou solide/gaz), des pièces solides, et de leurs combinaisons. En particulier, un tel accumulateur thermique peut être choisi parmi un réservoir de carburant d'un moteur du véhicule, un réservoir d'eau du véhicule, une pièce solide massive (par exemple de la structure ou du châssis du véhicule), ou un dispositif spécifique d'accumulation thermique exclusivement dédié à la fonction d'accumulation thermique (par exemple un réservoir de matériau à changement de phase liquide/gaz ou liquide/solide (par exemple une cire)) ou autre. Dans un troisième dispositif d'échange thermique, rien n'empêche de prévoir qu'au moins une boucle fluide intermédiaire (par exemple un circuit de carburant du véhicule, le circuit d'eau du véhicule...) soit interposée entre ledit troisième échangeur de chaleur et chaque accumulateur thermique associé au troisième dispositif d'échange thermique.

L'invention s'étend à un véhicule caractérisé en ce qu'il comprend au moins un dispositif selon l'invention de refroidissement d'au moins une charge chaude embarquée à bord du véhicule. Un véhicule selon l'invention peut en particulier être choisi parmi les aéronefs (avions de transport de passagers, les avions de transport de marchandises, hélicoptères, drones...), les engins spatiaux, les véhicules de transport terrestre (véhicules routiers ou sur rails...), les véhicules de transport aquatique ou maritime (navires, sous-marins...). L'invention s'étend en particulier avantageusement à un aéronef caractérisé en ce qu'il comprend au moins un dispositif selon l'invention de refroidissement d'au moins une charge chaude embarquée à bord de l'aéronef.

L'invention permet ainsi d'une part de faire varier de façon dynamique les capacités de refroidissement en fonction des besoins de refroidissement de chaque charge chaude embarquée à bord du véhicule, en utilisant ou non un ou plusieurs accumulateur(s) thermique(s) embarqué(s) par alimentation d'au moins un troisième échangeur de chaleur en mode direct, en plus du refroidissement du fluide caloporteur de la boucle fluide par de l'air extérieur grâce à chaque deuxième échangeur de chaleur. La réversibilité partielle d'au moins un troisième échangeur de chaleur de la boucle fluide permet en outre de refroidir chaque accumulateur thermique associé à ce troisième échangeur de chaleur de façon simple, économique, avec un faible poids et à faible volume. L'invention permet donc de gérer simultanément la température de chaque charge chaude et la température de chaque accumulateur thermique avec une seule boucle fluide. Il n'est pas nécessaire de prévoir un refroidissement de chaque accumulateur thermique par de l'air extérieur, ni un dispositif spécifique conçu à cette fin. En outre, il est possible de refroidir aussi bien chaque charge chaude et chaque accumulateur thermique alors que le véhicule est à l'arrêt, notamment lorsqu'il est au sol dans le cas d'un aéronef.

L'invention concerne également un procédé et un dispositif de refroidissement et un véhicule caractérisés en combinaison par tout ou partie des caractéristiques mentionnées ci-dessus ou ci-après.

D'autres buts, caractéristiques et avantages de l'invention apparaîtront à la lecture de la description suivante donnée à titre non limitatif d'un de ses modes de réalisation et qui se réfère aux figures annexées dans lesquelles :

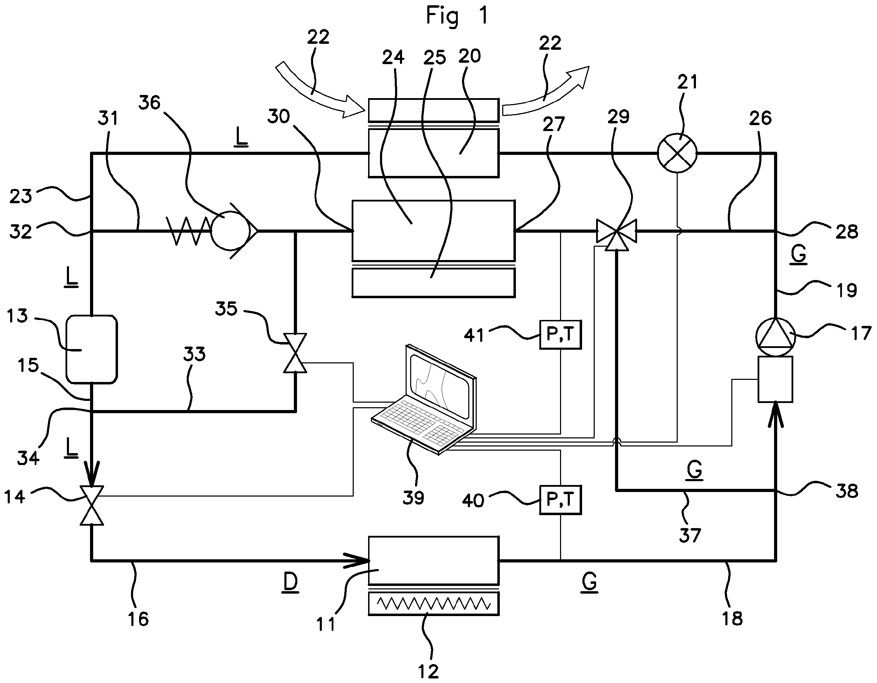

- la figure 1 est un schéma synoptique fonctionnel d'un mode de réalisation d'un dispositif de refroidissement selon l'invention,
- la figure 2 est un schéma synoptique fonctionnel représentant le dispositif de refroidissement de la figure 1 avec le troisième échangeur de chaleur alimenté en mode direct,
- la figure 3 est un schéma synoptique fonctionnel représentant le dispositif de refroidissement de la figure 1 avec le troisième échangeur de chaleur alimenté en mode inverse,
- la figure 4 est un schéma synoptique fonctionnel d'un autre mode de réalisation d'un dispositif de refroidissement selon l'invention.

Le dispositif selon l'invention de refroidissement de charges chaudes embarquées à bord de véhicule tel qu'un aéronef représenté sur les figures comprend un premier échangeur 11 de chaleur associée à au moins une charge 12 chaude à refroidir de façon à pouvoir transférer des calories depuis la charge 12 chaude vers un fluide caloporteur circulant dans une boucle fluide de circulation dans laquelle le premier échangeur 11 de chaleur est incorporé.

De préférence, le fluide caloporteur et la boucle fluide sont de type dit diphasique, c'est-à-dire sont agencés de telle sorte que le fluide caloporteur est à l'état liquide dans certaines portions de la boucle fluide dans lesquelles il est à une température relativement basse, à l'état gazeux dans certaines portions de la boucle fluide dans lesquelles il est à une température relativement élevée, et à l'état liquide/gaz dans certaines portions de la boucle fluide. Sur les figures, la lettre L apposée à côté d'une conduite signifie que le fluide caloporteur est à l'état liquide dans la conduite ; la lettre G signifie que le fluide caloporteur est à l'état gazeux ; la lettre D signifie que le fluide caloporteur est à l'état diphasique liquide/gaz.

La boucle fluide comporte un réservoir 13 de fluide caloporteur à l'état liquide. Entre le réservoir 13 et une entrée du premier échangeur 11 de chaleur, la boucle fluide comporte une vanne 14 de détente reliée au réservoir 13 par une conduite 15 et à une entrée du premier échangeur 11 de chaleur par une conduite 16. La vanne 14 de détente permet d'une part de détendre le fluide caloporteur en le faisant partiellement passer à l'état gazeux et en le refroidissant, d'autre part d'ajuster le débit en sortie de la vanne 14 de détente. La sortie de la vanne 14 de détente délivre donc un débit de fluide caloporteur diphasique à basse température, dit débit de fluide caloporteur froid, à l'entrée du premier échangeur 11 de chaleur.

Dans le cas d'une boucle fluide diphasique, le premier échangeur 11 de chaleur est un évaporateur, le fluide caloporteur s'évaporant et passant intégralement à l'état gazeux lors de sa traversée du premier échangeur 11 de chaleur, sous l'effet des calories apportées par la charge 12 chaude. La sortie du premier échangeur 11 de chaleur délivre donc un débit de fluide caloporteur à l'état gazeux et réchauffé (à une température supérieure à celle du débit de fluide caloporteur froid à l'entrée du premier échangeur de chaleur), dit débit de fluide caloporteur chaud.

La sortie du premier échangeur 11 de chaleur est reliée par une conduite 18 à un compresseur 17 motorisé. Le compresseur 17 délivre un débit de fluide caloporteur chaud gazeux à plus forte pression et plus forte température, et présente une sortie reliée par une conduite 19 à une entrée d'un deuxième échangeur 20 de chaleur par l'intermédiaire d'une électrovanne 21 optionnelle permettant si nécessaire d'ajuster le débit de fluide caloporteur délivré à l'entrée du deuxième échangeur 20 de chaleur.

Le deuxième échangeur 20 de chaleur est associé à un flux 22 d'air extérieur au véhicule, à une température très inférieure à la température du débit de fluide caloporteur chaud alimenté à l'entrée du deuxième échangeur 20 de chaleur. Ce flux 22 d'air extérieur peut être une circulation d'air générée par le déplacement du véhicule (air dynamique ou « ram air ») et/ou par un ventilateur embarqué lorsque le véhicule est à l'arrêt.

Dans le cas d'une boucle fluide diphasique, le deuxième échangeur 20 de chaleur est un condenseur et délivre en sortie un débit de fluide caloporteur refroidi et à l'état liquide. La sortie du deuxième échangeur 20 de chaleur est reliée par une conduite 23 à l'entrée du réservoir 13 de fluide caloporteur à l'état liquide.

La boucle fluide comporte un troisième échangeur 24 de chaleur relié en parallèle au deuxième échangeur 20 de chaleur, ce troisième échangeur 24 de chaleur étant associé à un accumulateur 25 thermique, distinct du fluide caloporteur, et embarqué à bord du véhicule. Un tel troisième échangeur 24 de chaleur peut être prévu pour diverses raisons, notamment pour augmenter les capacités de refroidissement de la boucle (le refroidissement par l'air extérieur étant nécessairement limité en termes de capacité et/ou disponibilité) et/ou pour des raisons de sécurité et/ou d'intégration ou autres.

Une première bouche 27 du troisième échangeur 24 de chaleur est reliée par une conduite 26 à la conduite 19 reliée à la sortie du compresseur 17 de façon à pouvoir recevoir au moins une partie du débit de fluide caloporteur chaud ayant servi à refroidir au moins une charge chaude, c'est-à-dire délivré par le compresseur 17. L'intersection de la conduite 26 avec la conduite 19 forme un premier nœud 28 de la boucle fluide. Une vanne 29 trois voies est interposée sur la conduite 26 entre le premier nœud 28 et la première bouche 27 du troisième échangeur 24 de chaleur de façon à permettre notamment d'ajuster le débit de fluide caloporteur alimenté à la première bouche 27 du troisième échangeur 24 de chaleur.

Le fluide caloporteur et l'accumulateur 25 thermique sont choisis de façon que le fluide caloporteur chaud ayant servi à refroidir au moins une charge chaude, c'est-à-dire délivré par le compresseur 17, puisse être refroidi par l'accumulateur 25 thermique, ce dernier étant à une température moyenne inférieure à la température du fluide caloporteur chaud délivré par le compresseur 17, notamment pour pouvoir assurer l'évacuation des calories du fluide caloporteur lorsque le deuxième échangeur de chaleur est insuffisant pour assurer l'intégralité de ce refroidissement. L'accumulateur 25 thermique est également choisi de façon à présenter une capacité calorifique aussi importante que possible, et une effusivité thermique aussi importante que possible, de façon à pouvoir absorber le plus possible les calories du fluide caloporteur chaud par l'intermédiaire du troisième échangeur 24 de chaleur, et à limiter les variations de température de l'accumulateur 25 thermique et du fluide caloporteur.

Par exemple, l'accumulateur 25 thermique est choisi dans le groupe formé des réservoirs de liquide, des réservoirs de gaz, des réservoirs de matériau à changement de phase, des pièces solides, et de leurs combinaisons. En particulier, un tel accumulateur thermique peut être choisi parmi un réservoir de carburant d'un moteur du véhicule, un réservoir d'eau du véhicule, une pièce solide massive (par exemple de la structure ou du châssis du véhicule), ou un dispositif spécifique d'accumulation thermique exclusivement dédié à la fonction d'accumulation thermique (par exemple un réservoir de matériau à changement de phase liquide/gaz).

Le troisième échangeur 24 de chaleur comprend une deuxième bouche 30 opposée à la première bouche 27, le fluide caloporteur s'écoulant dans le troisième échangeur 24 de chaleur entre ces bouches 27, 30 de façon à pouvoir échanger un flux thermique avec l'accumulateur 25 thermique. La deuxième bouche 30 du troisième échangeur 24 de chaleur est reliée à la conduite 23 s'étendant entre la sortie du deuxième échangeur 20 de chaleur et le réservoir 13, par une conduite 31, l'intersection de ces conduites 23, 31 formant un deuxième nœud 32 de la boucle fluide. De la sorte, un débit de fluide caloporteur refroidi par le troisième échangeur 24 de chaleur par transfert de calories vers l'accumulateur 25 thermique peut être délivré par la deuxième bouche 30 et mélangé au fluide caloporteur refroidi par le deuxième échangeur 20 de chaleur avant d'être réintroduit dans le réservoir 13.

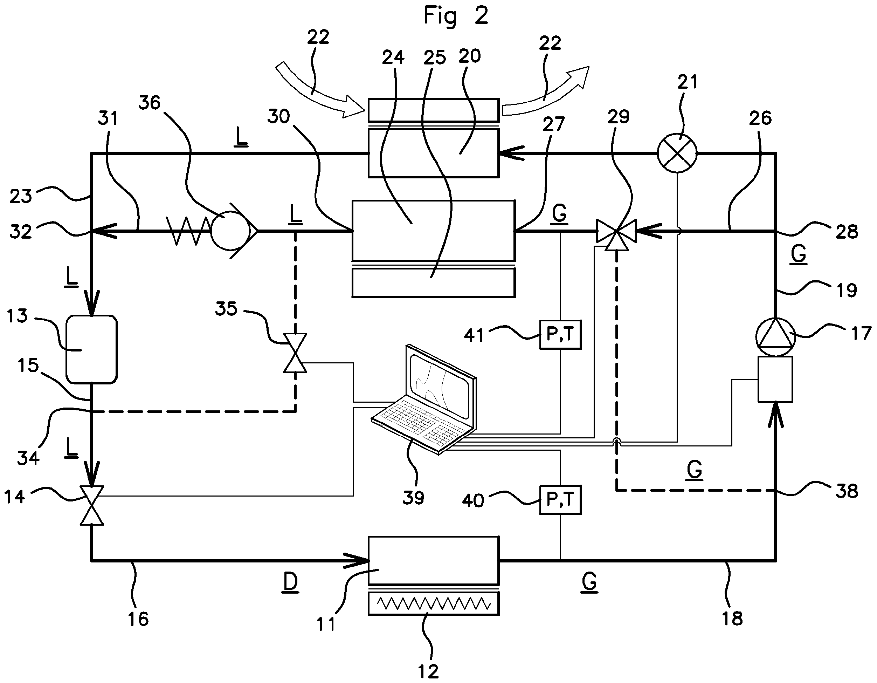

Ainsi, le troisième échangeur 24 de chaleur peut être alimenté en mode direct de façon à recevoir, sur la première bouche 27 qui constitue alors une entrée, au moins une partie du débit de fluide caloporteur chaud délivré par le compresseur 17 (ayant servi à refroidir la charge 12 chaude), à transférer des calories depuis ce fluide caloporteur chaud vers l'accumulateur 25 thermique de façon à refroidir le fluide caloporteur, et à délivrer le fluide caloporteur ainsi refroidi par la deuxième bouche 30, qui constitue alors une sortie, vers le réservoir 13. Le troisième échangeur 24 de chaleur alimenté en mode direct augmente donc les capacités de refroidissement de la boucle fluide. La figure 2 représente la boucle fluide lorsque le troisième échangeur 24 de chaleur est alimenté en mode direct, la vanne 35 de détente étant fermée. Les conduites 33, 37 du circuit d'inversion sont représentées en pointillés pour signifier le fait que le fluide caloporteur ne circule pas dans ces conduites.

Dans le cas d'une boucle diphasique, le fluide caloporteur chaud alimenté en mode direct à l'entrée du troisième échangeur 24 de chaleur est à l'état gazeux, et le fluide caloporteur refroidi après son passage dans le troisième échangeur 24 de chaleur et délivré à la sortie de ce dernier est de préférence à l'état liquide, le troisième échangeur 24 de chaleur constituant donc un condenseur lorsqu'il est alimenté en mode direct.

Lorsqu'il est alimenté en mode direct, le troisième échangeur 24 de chaleur est en parallèle au deuxième échangeur 20 de chaleur entre le premier nœud 28 et le deuxième nœud 32. Le troisième échangeur 24 de chaleur et le deuxième échangeur 20 de chaleur exercent tous les deux une fonction de condenseur.

Le dispositif de refroidissement selon l'invention comporte également un circuit d'inversion du sens de circulation du fluide caloporteur dans le troisième échangeur 24 de chaleur permettant selon un mode de circulation, dit mode inverse, d'introduire un débit de fluide caloporteur froid dans la deuxième bouche 30 du troisième échangeur 24 de chaleur en vue du refroidissement de l'accumulateur 25 thermique par transfert de calories depuis l'accumulateur 25 thermique vers ce fluide caloporteur circulant en sens inverse dans le troisième échangeur 24 de chaleur, ce fluide caloporteur se réchauffant et sortant de la première bouche 27 du troisième échangeur 24 de chaleur à une température supérieure, à l'état gazeux.

Pour ce faire, la sortie du réservoir 13 est reliée à la deuxième bouche 30 du troisième échangeur 24 de chaleur par une conduite 33 dont l'intersection à la sortie du réservoir 13 forme un troisième nœud 34 de la boucle fluide. Cette conduite 33 débouche dans la conduite 31 raccordée à la deuxième bouche 30 du troisième échangeur 24 de chaleur. Une vanne 35 de détente est interposée sur cette conduite 33 pour d'une part détendre le fluide caloporteur en le faisant passer partiellement à l'état gazeux et en le refroidissant (ledit débit de fluide caloporteur froid introduit dans la deuxième bouche 30 du troisième échangeur 24 de chaleur étant détendu à l'état diphasique liquide/gaz par la vanne 35 de détente), d'autre part ajuster ledit débit de fluide caloporteur froid délivré en mode inverse au troisième échangeur 24 de chaleur. La sortie de la vanne 35 de détente délivre donc, lorsque cette vanne 35 de détente est ouverte, un débit de fluide caloporteur diphasique détendu à basse température, dit débit de fluide caloporteur froid, à l'entrée du troisième échangeur 24 de chaleur.

Il est à noter qu'en variante non représentée, il est possible de prélever le débit de fluide caloporteur froid à la sortie de la vanne 14 de détente alimentant le premier échangeur 11 de chaleur, sur la conduite 16 reliant cette vanne 14 de détente à l'entrée du premier échangeur 11 de chaleur. Dans cette variante, la vanne 35 de détente peut être remplacée par une simple vanne commandée. Quoi qu'il en soit, le débit de fluide caloporteur froid alimentant le troisième échangeur 24 de chaleur en mode inverse est un débit prélevé sur le débit destiné à alimenter le premier échangeur 11 de chaleur.

Une soupape 36 est interposée sur la conduite 31 entre le deuxième nœud 32 d'intersection de cette conduite 31 avec la conduite 23 raccordée au deuxième échangeur 20 de chaleur et le troisième nœud 34 d'intersection de cette conduite 31 avec la conduite 33 délivrant le fluide caloporteur froid détendu issu de la vanne 35 de détente. Cette soupape 36 est agencée de façon à permettre la circulation du fluide caloporteur à l'état liquide en mode direct depuis la deuxième bouche 30 du troisième échangeur 24 de chaleur vers le deuxième nœud 32 et le réservoir 13, la soupape 36 étant ouverte sous l'effet de la pression du fluide caloporteur liquide. La soupape 36 est également agencée de façon à être fermée en mode inverse et interdire la circulation du fluide caloporteur froid liquide depuis le deuxième nœud 32 vers la deuxième bouche 30 du troisième échangeur 24 de chaleur. La fermeture de la soupape 36 résulte du fait que la pression du fluide caloporteur liquide issu du deuxième échangeur 20 de chaleur est supérieure à la pression du fluide caloporteur froid détendu issu de la vanne 35 de détente.

En mode inverse, le fluide caloporteur est réchauffé lors de sa traversée du troisième échangeur 24 de chaleur et sort du troisième échangeur 24 de chaleur par la première bouche 27 qui constitue une sortie du troisième échangeur 24 de chaleur.

Dans le cas d'une boucle diphasique, le fluide caloporteur froid alimenté en mode inverse à l'entrée du troisième échangeur 24 de chaleur est à l'état diphasique liquide/gaz, et après sa traversée du troisième échangeur 24 de chaleur, le fluide caloporteur réchauffé est à l'état gazeux. Le troisième échangeur 24 de chaleur constitue donc un évaporateur lorsqu'il est alimenté en mode inverse.

La vanne 29 trois voies interposée sur la conduite 26 entre le premier nœud 28 et la première bouche 27 du troisième échangeur 24 de chaleur reçoit en mode inverse le débit de fluide caloporteur réchauffé délivré par la première bouche 27. Cette vanne 29 trois voies présente une sortie reliée par une conduite 37 raccordée à la conduite 18 reliant le premier échangeur 11 de chaleur au compresseur 17 de façon à mélanger le débit de fluide caloporteur réchauffé par le troisième échangeur 24 de chaleur avec le débit de fluide caloporteur réchauffé par le premier échangeur 11 de chaleur, et ce à l'amont du compresseur 17. L'intersection de ces conduites 37, 18 constitue un quatrième nœud 38 de la boucle fluide. Le débit de fluide caloporteur ainsi réchauffé sortant du troisième échangeur 24 de chaleur est mélangé au débit de fluide caloporteur chaud ayant servi à refroidir une charge chaude 12, avant d'être introduit à l'entrée du deuxième échangeur 20 de chaleur pour être refroidi par l'air extérieur. Ainsi, en mode inverse, la première bouche 27 du troisième échangeur 24 de chaleur est reliée en communication de fluide à l'entrée du deuxième échangeur 20 de chaleur.

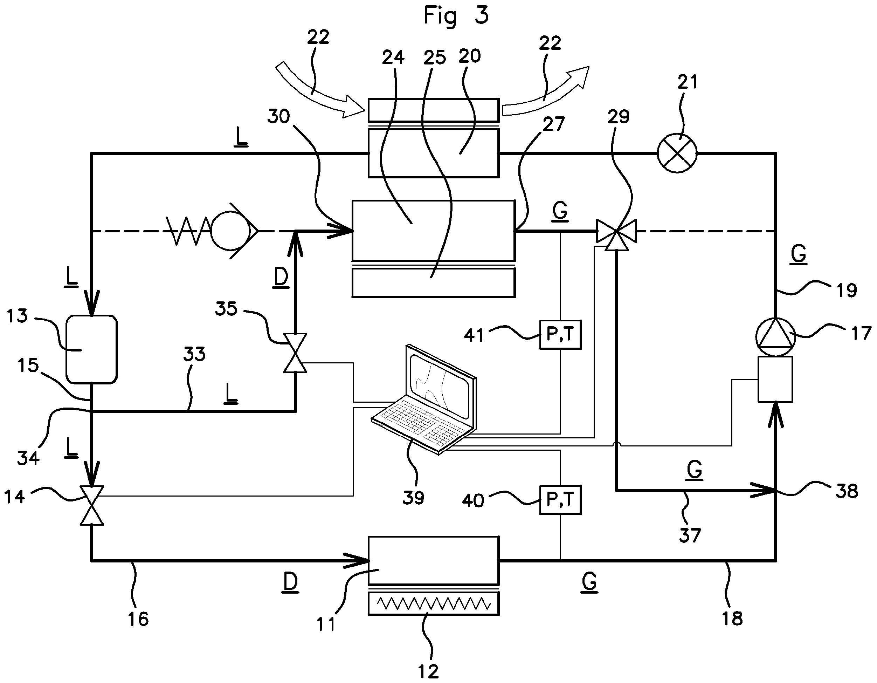

Lorsqu'il est alimenté en mode inverse, le troisième échangeur 24 de chaleur est en parallèle au deuxième échangeur 20 de chaleur entre le troisième nœud 34 et le quatrième nœud 38. Le troisième échangeur 24 de chaleur est aussi en parallèle au premier échangeur 11 de chaleur entre le troisième nœud 34 et le quatrième nœud 38 (dans le cas d'une boucle diphasique, le troisième échangeur 24 de chaleur et le premier échangeur 11 de chaleur exercent tous les deux une fonction d'évaporateur). La figure 3 représente la boucle fluide lorsque le troisième échangeur 24 de chaleur est alimenté en mode inverse, la vanne 35 de détente étant ouverte. Les conduites 26, 31 sont représentées en pointillés pour signifier le fait que le fluide caloporteur ne circule pas dans ces conduites.

Le troisième échangeur 24 de chaleur peut être constitué de tout échangeur de chaleur réversible, notamment pouvant faire office d'évaporateur en mode direct et de condenseur en mode inverse avec un fluide caloporteur diphasique. Par exemple, le troisième échangeur 24 de chaleur est choisi parmi les échangeurs à plaques et ailettes, les échangeurs à plaques, les échangeurs à tubes, les échangeurs à serpentin, les échangeurs à microcanaux, les échangeurs à contact direct. D'autres exemples sont possibles.

De préférence, l'intégralité des vannes 14, 21, 29, 35 sont des électrovannes pouvant être commandées par des signaux électriques de commande délivrés par une unité 39 de commande du dispositif de refroidissement. La sélection du mode d'alimentation du troisième échangeur 24 de chaleur entre le mode direct ou le mode inverse peut être effectuée entièrement automatiquement par l'unité 39 de commande, qui est programmée à cet effet. Pour ce faire, l'unité de 39 de commande est alors un automate ou un dispositif informatique programmable.

Un tel dispositif informatique programmable comprend au moins un processeur de traitement de données numériques, au moins une mémoire associée, une interface homme/machine, et au moins une carte de puissance adaptée pour délivrer des signaux électriques de commande des différentes électrovannes conformément à une logique de commande déterminée par la programmation du dispositif informatique.

La boucle fluide comporte également différents capteurs de température et de pression, notamment par exemple au moins un capteur 40 de température et de pression à la sortie du premier échangeur de chaleur, et au moins un capteur 41 de température et de pression à la première bouche 27 du troisième échangeur 24 de chaleur. Ces capteurs 40, 41 sont reliés à l'unité 39 de commande pour délivrer des signaux de mesure représentatifs de la température et de la pression du fluide caloporteur.

La vanne 29 trois voies et la vanne 35 de détente (délivrant en mode inverse le fluide caloporteur froid détendu à la deuxième bouche 30 du troisième échangeur 24 de chaleur) sont des vannes commandées par l'unité 39 de commande et constituent un dispositif d'inversion commandé du mode d'alimentation du troisième échangeur 24 de chaleur.

Ce dispositif d'inversion est commandé par l'unité 39 de commande :
- en mode direct lorsque des critères de besoin de refroidissement sont remplis,
- en mode inverse lorsque lesdits critères de besoin de refroidissement ne sont pas remplis.

Ces critères de besoin de refroidissement comportent par exemple au moins un critère selon lequel la température de la charge 12 chaude est supérieure à une température maximale admissible. En effet, si ce critère est rempli, les besoins de refroidissement sont relativement importants, de sorte que le troisième échangeur 24 de chaleur est alimenté en mode direct de façon que le dispositif de refroidissement fournisse une capacité de refroidissement plus importante -notamment maximale-. Au contraire, si la température de la charge 12 chaude n'est pas supérieure à une telle température maximale admissible, les besoins de refroidissement sont moins importants, et il est possible de ne pas utiliser le troisième 24 échangeur de chaleur en mode direct pour le refroidissement de la charge 12 chaude, et de l'alimenter en mode inverse pour refroidir au contraire ce troisième 24 échangeur de chaleur. Ladite température maximale admissible peut être déterminée selon la charge chaude à refroidir, en fonction des besoins en refroidissement de cette charge chaude.

Il est également à noter qu'il est possible d'envisager toute combinaison logique de sélection de l'alimentation du troisième échangeur 24 de chaleur, selon les besoins de refroidissement, en fonction des architectures et des combinaisons des différents échangeurs de chaleur et des applications.

Également, d'autres critères représentatifs des besoins de refroidissement que la température de la charge chaude peuvent être utilisés, en variante ou en combinaison, pour sélectionner l'alimentation en mode direct ou en mode inverse du troisième échangeur 24 de chaleur : par exemple l'intensité d'un courant électrique consommé par la charge 12 chaude ; un paramètre de fonctionnement de la charge 12 chaude représentatif du fait que cette dernière présente besoins de refroidissement plus important ; la température de l'air extérieur ; le débit disponible d'air extérieur pour le deuxième échangeur de chaleur ; la pression de condensation ; la température de l'accumulateur thermique ...

De même, la logique de sélection d'alimentation en mode direct ou en mode inverse du troisième échangeur 24 de chaleur peut faire l'objet de nombreuses variantes de réalisation et peut être plus ou moins complexe : il peut s'agir d'un asservissement en boucle fermée comprenant une ou plusieurs boucle(s) pour réaliser une régulation appropriée, proportionnelle et/ou intégrale et/ou dérivée ou autre.

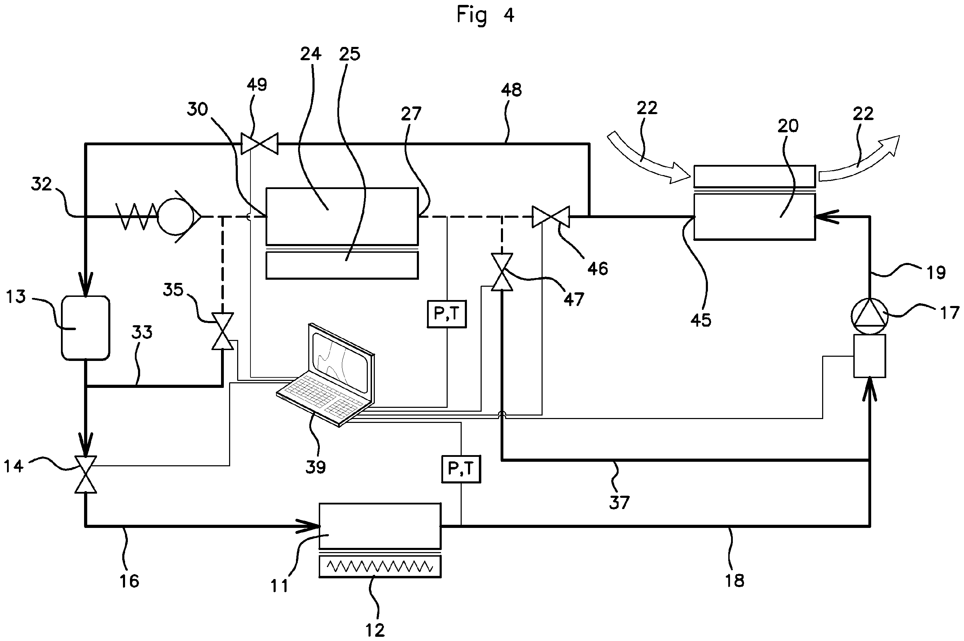

Le dispositif de refroidissement selon l'invention conforme au deuxième mode de réalisation représenté figure 4 diffère du précédent par le fait que le troisième échangeur 24 de chaleur est relié en série à l'aval du deuxième échangeur 20 de chaleur. La conduite 19 à la sortie du compresseur 17 est reliée à l'entrée du deuxième échangeur 20 de chaleur. La sortie 45 du deuxième échangeur 20 de chaleur est reliée à la première bouche 27 du troisième échangeur 24 de chaleur par l'intermédiaire d'une vanne 46 deux voies commandée. La première bouche 27 du troisième échangeur 24 de chaleur est aussi reliée à la conduite 37 d'inversion par l'intermédiaire d'une vanne 47 d'inversion deux voies commandée, les deux vannes 46, 47 deux voies commandées étant reliées à la bouche 27 du troisième échangeur 24 de chaleur en parallèle l'une par rapport à l'autre. La sortie 45 du deuxième échangeur 20 de chaleur est par ailleurs reliée à l'amont de la vanne 46 deux voies commandée à une conduite 48 de dérivation qui la relie, par l'intermédiaire d'une vanne 49 commandée, au deuxième nœud 32 de la boucle fluide et à l'entrée du réservoir 13. En mode direct, la vanne 47 d'inversion est fermée. Les vannes 46 et 49 peuvent être ouvertes ou fermées, mais devraient de préférence être commandées de façon opposées. Si la vanne 46 est ouverte, la vanne 49 est fermée pour faire passer le débit de fluide au travers du troisième échangeur 24. Si la vanne 46 est fermée, la vanne 49 est ouverte pour dériver le débit de fluide caloporteur directement au réservoir 13, ce qui peut procurer une situation intermédiaire entre le mode direct et le mode inverse, notamment avant de passer en mode inverse à partir du mode direct. En mode inverse, la vanne 47 d'inversion est ouverte, tandis que la vanne 46 interposée entre la sortie 45 du deuxième échangeur 20 de chaleur et la première bouche 27 du troisième échangeur 24 de chaleur est fermée. La vanne 49 sur la conduite 48 de dérivation est ouverte.

Un dispositif et un procédé de refroidissement selon l'invention peuvent faire l'objet de nombreuses variantes de réalisation par rapport aux modes de réalisation représentés sur les figures.

En particulier, le dispositif de refroidissement peut comporter plusieurs charges chaudes et/ou plusieurs premiers échangeurs 11 de chaleur reliés en série ou en parallèle dans la boucle fluide et/ou plusieurs deuxièmes échangeurs 20 de chaleur reliés en série ou en parallèle dans la boucle fluide et/ou plusieurs troisièmes échangeurs 24 de chaleur reliés en série ou en parallèle dans la boucle fluide et/ou plusieurs accumulateurs 25 thermiques.

Chaque troisième échangeur de chaleur est agencé dans ladite boucle fluide de façon à pouvoir, en mode direct, recevoir une partie dudit débit de fluide caloporteur chaud issu d'au moins un premier échangeur de chaleur et transférer des calories depuis ce fluide caloporteur chaud vers l'accumulateur thermique. Chaque troisième échangeur de chaleur est associé à un circuit d'inversion et est agencé dans la boucle fluide de façon à pouvoir, en mode inverse, recevoir un débit de fluide caloporteur froid et transférer des calories depuis l'accumulateur thermique vers le fluide caloporteur en vue du refroidissement de cet accumulateur thermique.

Chaque échangeur de chaleur de la boucle fluide peut être incorporé dans un dispositif d'échange thermique plus complexe qu'un simple échangeur pour échanger un flux thermique avec le fluide caloporteur. Ainsi, le premier échangeur de chaleur peut être incorporé dans un premier dispositif thermique plus complexe associé à au moins une charge chaude ; le deuxième échangeur de chaleur peut être incorporé dans un deuxième dispositif thermique plus complexe associé à l'air extérieur au véhicule ; le troisième échangeur de chaleur peut être incorporé dans un troisième dispositif thermique plus complexe associé à au moins un accumulateur thermique.

La vanne 35 de détente et la soupape 36 peuvent être incorporées dans un même composant placé au nœud de la conduite 33 provenant de la sortie du réservoir 13 et de la conduite 31 raccordée à la deuxième bouche 30 du troisième échangeur de chaleur. La conduite 37 reliée à la sortie de la vanne trois voies peut être reliée non pas à l'amont du compresseur 17, mais à l'amont d'un étage seulement de ce compresseur 17, c'est-à-dire entre deux étages de compresseur 17. Un compresseur spécifique peut aussi en variante être prévu pour assurer la circulation du fluide caloporteur en mode inverse. L'une au moins des vannes de détente peut être remplacée par tout autre dispositif de détente, par exemple un orifice de détente, un tube capillaire, une turbine...).

L'invention s'applique au refroidissement de toute charge chaude -notamment choisie dans le groupe formé des dispositifs électriques (par exemple une source de puissance électrique d'alimentation d'un réseau électrique à bord du véhicule) et/ou électroniques et/ou informatiques, de l'air de compartiments à refroidir, de l'air de cabine, des volumes de liquide (notamment choisis parmi les volumes de carburant, les volumes d'eau et les volumes de liquides caloporteurs distincts de l'eau et du carburant). Elle s'applique au refroidissement de toute charge chaude à bord de tout véhicule, et en particulier pouvant être choisi parmi les aéronefs (avions de transport de passagers, les avions de transport de marchandises, avions de combat, hélicoptères, drones...), les engins spatiaux, les véhicules de transport terrestre (véhicules routiers ou sur rails...), les véhicules de transport aquatique ou maritime (navires, sous-marins...).

## Revendications

1. Procédé de refroidissement d'au moins une charge chaude à bord d'un véhicule tel qu'un aéronef comportant une boucle fluide de circulation d'un fluide caloporteur dans lequel :
- pour chaque charge (12) chaude à refroidir, un débit dudit fluide caloporteur, dit débit de fluide caloporteur froid, est introduit dans un échangeur de chaleur, dit premier échangeur (11) de chaleur, d'un premier dispositif d'échange thermique associé à la charge (12) chaude de façon à transférer des calories de cette dernière vers le fluide caloporteur, refroidir la charge chaude et produire un débit dudit fluide caloporteur, dit débit de fluide caloporteur chaud, à une température supérieure à celle dudit débit de fluide caloporteur froid,
- au moins une partie dudit débit de fluide caloporteur chaud issu d'au moins un tel premier échangeur (11) de chaleur est introduite dans au moins un échangeur de chaleur, dit deuxième échangeur (20) de chaleur, d'un deuxième dispositif d'échange thermique agencé pour pouvoir la refroidir par de l'air extérieur au véhicule,
- un débit dudit fluide caloporteur est introduit dans au moins un échangeur de chaleur, dit troisième échangeur (24) de chaleur, d'un troisième dispositif d'échange thermique agencé pour pouvoir échanger un flux thermique entre ce débit dudit fluide caloporteur et au moins un accumulateur (25) thermique, distinct dudit fluide caloporteur, embarqué à bord du véhicule,
- lorsque des critères de besoin de refroidissement sont remplis, au moins un tel troisième échangeur (24) de chaleur est alimenté selon un mode de circulation, dit mode direct, dans lequel il reçoit, sur une première bouche (27) de ce troisième échangeur (24) de chaleur, au moins une partie dudit débit de fluide caloporteur chaud issu d'au moins un tel premier échangeur (11) de chaleur, ledit troisième dispositif d'échange thermique correspondant transférant des calories depuis ce fluide caloporteur chaud vers l'accumulateur (25) thermique de façon à refroidir ledit fluide caloporteur, le fluide caloporteur ainsi refroidi étant délivré par une deuxième bouche (30) du troisième échangeur (24) de chaleur,
**caractérisé par** l'étape, dans lequel:
- lorsque lesdits critères de besoin de refroidissement ne sont pas remplis, au moins un tel troisième (24) échangeur de chaleur est alimenté selon un mode de circulation, dit mode inverse dans lequel il reçoit, sur ladite deuxième bouche (30) de ce troisième échangeur (24) de chaleur, un débit dudit fluide caloporteur et ledit troisième dispositif d'échange thermique correspondant transfère des calories depuis l' accumulateur (25) thermique vers ce fluide caloporteur de façon à refroidir cet accumulateur (25) thermique, et le fluide caloporteur ainsi réchauffé sort de ce troisième échangeur (24) de chaleur par ladite première bouche (27) de ce troisième échangeur (24) de chaleur et dans lequel la boucle fluide est une boucle diphasique.

2. Procédé selon la revendication 1 **caractérisé en ce qu'**en mode inverse le débit de fluide caloporteur réchauffé par ce troisième échangeur (24) de chaleur est mélangé avec le débit de fluide caloporteur réchauffé par un premier échangeur (11) de chaleur.

3. Procédé selon l'une quelconque des revendications 1 à 2 **caractérisé en ce qu'**en mode inverse la deuxième bouche de ce troisième échangeur (24) de chaleur reçoit au moins une partie d'un débit de fluide caloporteur froid dont une autre partie forme ledit débit de fluide caloporteur froid introduit dans un premier échangeur de chaleur.

4. Procédé selon l'une quelconque des revendications 1 à 3 **caractérisé en ce qu'**en mode inverse ce troisième échangeur (24) de chaleur reçoit sur sa deuxième bouche (30) un débit de fluide caloporteur, dit débit de fluide caloporteur refroidi, issu d'un réservoir (13) de fluide caloporteur par l'intermédiaire d'un dispositif (35) de détente.

5. Procédé selon l'une quelconque des revendications 1 à 4 **caractérisé en ce que** :
- lesdits critères de besoin de refroidissement comprennent au moins un critère, dit critère de température, selon lequel la température d'au moins une charge (12) chaude est supérieure à une température maximale admissible,
- la température de chaque charge (12) chaude pour laquelle au moins un critère de température est défini est mesurée,
- au moins un tel troisième échangeur (24) de chaleur est alimenté :
∘ en mode direct lorsque la température mesurée de chaque charge (12) chaude remplit chaque critère de température,
∘ en mode inverse au moins lorsque la température mesurée de chaque charge (12) chaude ne remplit pas chaque critère de température.

6. Procédé selon l'une des revendications 1 à 5 **caractérisé en ce que** chaque accumulateur (25) thermique associé à un troisième dispositif d'échange thermique est choisi dans le groupe formé des réservoirs de liquide, des réservoirs de gaz, des réservoirs de matériau à changement de phase, des pièces solides, et de leurs combinaisons.

7. Dispositif de refroidissement d'au moins une charge chaude à bord d'un véhicule tel qu'un aéronef comportant une boucle fluide de circulation d'un fluide caloporteur comprenant :
- pour chaque charge (12) chaude à refroidir, un premier dispositif d'échange thermique associé à la charge (12) chaude de façon à pouvoir transférer des calories de cette dernière vers un débit dudit fluide caloporteur, dit débit de fluide caloporteur froid, introduit dans un échangeur de chaleur, dit premier échangeur (11) de chaleur, de ce premier dispositif d'échange thermique, refroidir la charge (12) chaude et produire un débit dudit fluide caloporteur, dit débit de fluide caloporteur chaud, à une température supérieure à celle dudit débit de fluide caloporteur froid,
- au moins un deuxième dispositif d'échange thermique agencé pour pouvoir refroidir par de l'air extérieur au véhicule au moins une partie dudit débit de fluide caloporteur chaud issu d'au moins un premier échangeur (11) de chaleur et introduite dans un échangeur de chaleur, dit deuxième échangeur (20) de chaleur, de ce deuxième dispositif d'échange thermique,
- au moins un troisième dispositif d'échange thermique agencé pour pouvoir échanger un flux thermique entre au moins un accumulateur (25) thermique, distinct dudit fluide caloporteur, embarqué à bord du véhicule et un débit dudit fluide caloporteur introduit dans un échangeur de chaleur, dit troisième échangeur (24) de chaleur, de ce troisième dispositif d'échange thermique,
- pour chaque troisième échangeur (24) de chaleur, un circuit, dit circuit d'inversion, comprenant un dispositif (29, 35, 36) d'inversion commandé comportant au moins une vanne commandée, ledit circuit d'inversion et le dispositif d'inversion commandé étant agencés pour pouvoir faire circuler ledit fluide caloporteur dans le troisième échangeur (24) de chaleur selon un mode de circulation choisi parmi :
∘ un mode direct dans lequel le troisième échangeur (24) de chaleur reçoit, sur une première bouche (27) de ce troisième échangeur (24) de chaleur, au moins une partie dudit débit de fluide caloporteur chaud issu d'au moins un premier échangeur (11) de chaleur et le troisième dispositif d'échange thermique transfère des calories depuis ce fluide caloporteur chaud vers l'accumulateur (25) thermique de façon à refroidir ce fluide caloporteur chaud, le fluide caloporteur ainsi refroidi étant délivré par une deuxième bouche (30) du troisième échangeur (24) de chaleur, **caractérisé par**:
o un mode inverse dans lequel le troisième échangeur (24) de chaleur reçoit, sur la deuxième bouche (30) de ce troisième échangeur (24) de chaleur, un débit dudit fluide caloporteur et le troisième dispositif d'échange thermique correspondant transfère des calories depuis l' accumulateur (25) thermique vers ce débit de fluide caloporteur de façon à refroidir l'accumulateur (25) thermique, le fluide caloporteur ainsi réchauffé sortant de ce troisième échangeur (24) de chaleur par ladite première bouche (27) de ce troisième échangeur (24) de chaleur et dans lequel la boucle fluide est une boucle diphasique.

8. Dispositif selon la revendication 7 **caractérisé en ce qu'**en mode inverse la première bouche (27) de ce troisième échangeur (24) de chaleur est reliée à une conduite (18) reliée à la sortie du premier échangeur de chaleur de façon à mélanger le débit de fluide caloporteur réchauffé par le troisième échangeur (24) de chaleur avec le débit de fluide caloporteur réchauffé par ce premier échangeur (11) de chaleur.

9. Dispositif selon l'une quelconque des revendications 7 à 8 **caractérisé en ce qu'**il comporte un réservoir (13) de fluide caloporteur et au moins un dispositif (35) de détente interposé entre le réservoir de fluide caloporteur et un tel troisième (24) échangeur de chaleur et agencé pour délivrer, en mode inverse, à ce troisième échangeur (24) de chaleur un débit de fluide caloporteur, dit débit de fluide caloporteur refroidi, à une température inférieure à celle de chaque accumulateur (25) thermique associé à ce troisième échangeur de chaleur.

10. Dispositif selon l'une des revendications 7 à 9, **caractérisé en ce qu'**il comporte une unité (39) de commande adaptée pour pouvoir commander au moins un tel dispositif (29, 35, 36) d'inversion :
- en mode direct lorsque des critères de besoin de refroidissement sont remplis,
- en mode inverse lorsque lesdits critères de besoin de refroidissement ne sont pas remplis.

11. Dispositif selon la revendication 10 **caractérisé en ce que** lesdits critères de besoin de refroidissement comprennent au moins un critère, dit critère de température, selon lequel la température d'au moins une charge (12) chaude est supérieure à une température maximale admissible, et **en ce que** l'unité (39) de commande est adaptée pour :
- recevoir des signaux de mesure de température de chaque charge chaude pour laquelle au moins un critère de température est défini,
- vérifier si chaque critère de température est rempli,
- commander au moins un tel dispositif (29, 35, 36) d'inversion :
∘ en mode direct lorsque la température mesurée de chaque charge (12) chaude remplit chaque critère de température,
∘ en mode inverse au moins lorsque la température mesurée de chaque charge (12) chaude ne remplit pas chaque critère de température.

12. Dispositif selon l'une quelconque des revendications 7 à 11 **caractérisé en ce que** pour chaque premier échangeur (11) de chaleur d'un premier dispositif d'échange thermique associé à une charge (12) chaude, un unique troisième échangeur (24) de chaleur est agencé pour pouvoir recevoir, en mode direct, une partie du débit de fluide caloporteur chaud issu de ce premier échangeur (11) de chaleur.

13. Dispositif selon l'une quelconque des revendications 7 à 12 **caractérisé en ce qu'**un dispositif (29, 35, 36) d'inversion commandé d'au moins un tel troisième échangeur de chaleur comporte une vanne (29) trois voies commandée présentant :
- une sortie reliée à une conduite (18) à l'aval d'au moins un premier échangeur (11) de chaleur,
- une entrée reliée à une conduite (19) reliée à un deuxième échangeur (20) de chaleur,
- une entrée/sortie reliée à une première bouche (27) du troisième échangeur (24) de chaleur,
et **en ce que** l'unité (39) de commande est reliée à la vanne (29) trois voies et adaptée pour :
- en mode direct relier l'entrée de la vanne (29) trois voies à son entrée/sortie qui fait office de sortie pour un débit dudit fluide caloporteur prélevé de la conduite (19) d'entrée du deuxième échangeur (20) de chaleur,
- en mode inverse relier l'entrée/sortie de la vanne (29) trois voies à sa sortie, l'entrée/sortie faisant office d'entrée pour un débit dudit fluide caloporteur issu du troisième échangeur (24) de chaleur, ledit fluide caloporteur issu de la sortie de la vanne (29) trois voies étant mélangé audit fluide caloporteur de ladite conduite (18) de sortie.

14. Dispositif selon l'une des revendications 7 à 13 **caractérisé en ce que** le troisième échangeur (24) comporte une deuxième bouche (30) reliée :
- en mode direct à une conduite (23) de sortie d'au moins un deuxième échangeur (20) de chaleur, ledit fluide caloporteur issu de cette deuxième bouche (30) du troisième échangeur (24) étant mélangé audit fluide caloporteur de cette conduite (23) de sortie,
- en mode inverse à un dispositif (35) de détente d'un débit dudit fluide caloporteur.

15. Dispositif selon l'une des revendications 7 à 14 **caractérisé en ce que** chaque accumulateur (25) thermique associé à un troisième dispositif d'échange thermique est choisi dans le groupe formé des réservoirs de liquide, des réservoirs de gaz, des réservoirs de matériau à changement de phase, des pièces solides, et de leurs combinaisons.

16. Véhicule **caractérisé en ce qu'**il comprend un dispositif selon l'une des revendications 7 à 15 de refroidissement d'au moins une charge (12) chaude embarquée à bord du véhicule.

## Patentansprüche

1. Verfahren zum Kühlen mindestens einer heißen Last an Bord eines Fahrzeugs wie eines Luftfahrzeugs, umfassend einen Fluidkreis für die Zirkulation eines Kühlmittels, wobei:
- für jede zu kühlende heiße Last (12) ein Durchsatz des Kühlmittels, so genannter kalter Kühlmitteldurchsatz, in einen Wärmetauscher, so genannten ersten Wärmetauscher (11), einer ersten Wärmetauschvorrichtung eingeleitet wird, die der heißen Last (12) zugehörig ist, um Kalorien dieser Letzteren auf das Kühlmittel zu übertragen, die heiße Last zu kühlen und einen Durchsatz des Kühlmittels, so genannten heißen Kühlmitteldurchsatz, mit einer Temperatur zu erzeugen, die höher ist als jene des kalten Kühlmitteldurchsatzes,
- mindestens ein Teil des heißen Kühlmitteldurchsatzes, der aus mindestens einem solchen ersten Wärmetauscher (11) stammt, in mindestens einen Wärmetauscher, so genannten zweiten Wärmetauscher (20), einer zweiten Wärmetauschvorrichtung eingeleitet wird, die angeordnet ist, um ihn durch Fahrzeugaußenluft zu kühlen,
- ein Durchsatz des Kühlmittels in mindestens einen Wärmetauscher, so genannten dritten Wärmetauscher (24), einer dritten Wärmetauschvorrichtung eingeleitet wird, die angeordnet ist, um einen Wärmestrom zwischen diesem Durchsatz des Kühlmittels und mindestens einem Wärmespeicher (25) auszutauschen, der von dem Kühlmittel verschieden ist und an Bord des Fahrzeugs mitgeführt wird,
- wenn Kühlbedarfskriterien erfüllt sind, mindestens ein solcher dritter Wärmetauscher (24) gemäß einem Zirkulationsmodus, so genannten Direktmodus, versorgt wird, in dem er auf einer ersten Mündung (27) dieses dritten Wärmetauschers (24) mindestens einen Teil des heißen Kühlmitteldurchsatzes empfängt, der aus mindestens einem solchen ersten Wärmetauscher (11) stammt, wobei die entsprechende dritte Wärmetauschvorrichtung Kalorien ausgehend von diesem heißen Kühlmittel auf den Wärmespeicher (25) überträgt, um das Kühlmittel zu kühlen, wobei das so gekühlte Kühlmittel durch eine zweite Mündung (30) des dritten Wärmetauschers (24) abgegeben wird,
**gekennzeichnet durch** den Schritt, wobei:
- wenn die Kühlbedarfskriterien nicht erfüllt sind, mindestens ein solcher dritter (24) Wärmetauscher gemäß einem Zirkulationsmodus, so genannten Umkehrmodus, versorgt wird, in dem er auf der zweiten Mündung (30) dieses dritten Wärmetauschers (24) einen Durchsatz des Kühlmittels empfängt und die entsprechende dritte Wärmetauschvorrichtung Kalorien ausgehend von dem Wärmespeicher (25) auf dieses Kühlmittel überträgt, um diesen Wärmespeicher (25) zu kühlen, und das so erwärmte Kühlmittel aus diesem dritten Wärmetauscher (24) durch die erste Mündung (27) dieses dritten Wärmetauschers (24) austritt und in dem der Fluidkreis ein Zweiphasenkreis ist.

2. Verfahren nach Anspruch 1, **dadurch gekennzeichnet, dass** im Umkehrmodus der durch diesen dritten Wärmetauscher (24) erwärmte Kühlmitteldurchsatz mit dem durch einen ersten Wärmetauscher (11) erwärmten Kühlmitteldurchsatz gemischt wird.

3. Verfahren nach einem der Ansprüche 1 bis 2, **dadurch gekennzeichnet, dass** im Umkehrmodus die zweite Mündung dieses dritten Wärmetauschers (24) mindestens einen Teil eines kalten Kühlmitteldurchsatzes empfängt, von dem ein anderer Teil den kalten Kühlmitteldurchsatz bildet, der in einen ersten Wärmetauscher eingeleitet wird.

4. Verfahren nach einem der Ansprüche 1 bis 3, **dadurch gekennzeichnet, dass** im Umkehrmodus dieser dritte Wärmetauscher (24) auf seiner zweiten Mündung (30) einen Kühlmitteldurchsatz, so genannten gekühlten Kühlmitteldurchsatz, der aus einem Kühlmitteltank (13) stammt, mittels einer Expansionsvorrichtung (35) empfängt.

5. Verfahren nach einem der Ansprüche 1 bis 4, **dadurch gekennzeichnet, dass**:
- die Kühlbedarfskriterien mindestens ein Kriterium, so genanntes Temperaturkriterium, umfassen, wonach die Temperatur mindestens einer heißen Last (12) höher ist als eine zulässige Höchsttemperatur,
- die Temperatur jeder heißen Last (12), für die mindestens ein Temperaturkriterium definiert ist, gemessen wird,
- mindestens ein solcher dritter Wärmetauscher (24) versorgt wird:
o im Direktmodus, wenn die gemessene Temperatur jeder heißen Last (12) jedes Temperaturkriterium erfüllt,
o im Umkehrmodus mindestens, wenn die gemessene Temperatur jeder heißen Last (12) nicht jedes Temperaturkriterium erfüllt.

6. Verfahren nach einem der Ansprüche 1 bis 5, **dadurch gekennzeichnet, dass** jeder Wärmespeicher (25), der einer dritten Wärmetauschvorrichtung zugehörig ist, ausgewählt wird aus der Gruppe, gebildet von Flüssigkeitstanks, Gastanks, Phasenänderungsmitteltanks, Festkörpern und ihren Kombinationen.

7. Vorrichtung zum Kühlen mindestens einer heißen Last an Bord eines Fahrzeugs wie Luftfahrzeugs, umfassend einen Fluidkreis für die Zirkulation eines Kühlmittels, umfassend:
- für jede zu kühlende heiße Last (12) eine erste Wärmetauschvorrichtung, die der heißen Last (12) zugehörig ist, um Kalorien dieser Letzteren auf einen Durchsatz des Kühlmittels, so genannten kalten Kühlmitteldurchsatz, übertragen zu können, der in einen Wärmetauscher, so genannten ersten Wärmetauscher (11), dieser ersten Wärmetauschvorrichtung eingeleitet wird, die heiße Last (12) zu kühlen und einen Durchsatz des Kühlmittels, so genannten heißen Kühlmitteldurchsatz, mit einer Temperatur zu erzeugen, die höher ist als jene des kalten Kühlmitteldurchsatzes,
- mindestens eine zweite Wärmetauschvorrichtung, die angeordnet ist, um durch Fahrzeugaußenluft mindestens einen Teil des heißen Kühlmitteldurchsatzes, der aus mindestens einem ersten Wärmetauscher (11) stammt und in einen Wärmetauscher, so genannten zweiten Wärmetauscher (20), dieser zweiten Wärmetauschvorrichtung eingeleitet wird, kühlen zu können,
- mindestens eine dritte Wärmetauschvorrichtung, die angeordnet ist, um einen Wärmestrom zwischen mindestens einem Wärmespeicher (25), der von dem Kühlmittel verschieden ist und an Bord des Fahrzeugs mitgeführt wird, und einem Durchsatz des Kühlmittels, der in einen Wärmetauscher, so genannten dritten Wärmetauscher (24), dieser dritten Wärmetauschvorrichtung eingeleitet wird, austauschen zu können,
- für jeden dritten Wärmetauscher (24) einen Kreislauf, so genannten Umkehrkreislauf, umfassend eine gesteuerte Umkehrvorrichtung (29, 35, 36), die mindestens ein gesteuertes Ventil umfasst, wobei der Umkehrkreislauf und die gesteuerte Umkehrvorrichtung angeordnet sind, um das Kühlmittel in dem dritten Wärmetauscher (24) gemäß einem Zirkulationsmodus zirkulieren zu lassen, der ausgewählt wird aus:
∘ einem Direktmodus, in dem der dritte Wärmetauscher (24) auf einer ersten Mündung (27) dieses dritten Wärmetauschers (24) mindestens einen Teil des heißen Kühlmitteldurchsatzes empfängt, der aus mindestens einem ersten Wärmetauscher (11) stammt, und die dritte Wärmetauschvorrichtung Kalorien ausgehend von diesem heißen Kühlmittel auf den Wärmespeicher (25) überträgt, um dieses heiße Kühlmittel zu kühlen, wobei das so gekühlte Kühlmittel durch eine zweite Mündung (30) des dritten Wärmetauschers (24) abgegeben wird,
**gekennzeichnet durch**:
∘ einen Umkehrmodus, in dem der dritte Wärmetauscher (24) auf der zweiten Mündung (30) dieses dritten Wärmetauschers (24) einen Durchsatz des Kühlmittels empfängt und die entsprechende dritte Wärmetauschvorrichtung Kalorien ausgehend von dem Wärmespeicher (25) auf diesen Kühlmitteldurchsatz überträgt, um den Wärmespeicher (25) zu kühlen, wobei das so erwärmte Kühlmittel aus diesem dritten Wärmetauscher (24) durch die erste Mündung (27) dieses dritten Wärmetauschers (24) austritt und in dem der Fluidkreis ein Zweiphasenkreis ist.

8. Vorrichtung nach Anspruch 7, **dadurch gekennzeichnet, dass** im Umkehrmodus die erste Mündung (27) dieses dritten Wärmetauschers (24) mit einer Leitung (18) verbunden ist, die mit dem Austritt des ersten Wärmetauschers verbunden ist, um den durch den dritten Wärmetauscher (24) erwärmten Kühlmitteldurchsatz mit dem durch diesen ersten Wärmetauscher (11) erwärmten Kühlmitteldurchsatz zu mischen.

9. Vorrichtung nach einem der Ansprüche 7 bis 8, **dadurch gekennzeichnet, dass** sie einen Kühlmitteltank (13) und mindestens eine Expansionsvorrichtung (35) umfasst, die zwischen dem Kühlmitteltank und einem solchen dritten Wärmetauscher (24) eingefügt und angeordnet ist, um im Umkehrmodus an diesen dritten Wärmetauscher (24) einen Kühlmitteldurchsatz, so genannten gekühlten Kühlmitteldurchsatz, mit einer Temperatur abzugeben, die niedriger ist als jene jedes Wärmespeichers (25), der diesem dritten Wärmetauscher zugehörig ist.

10. Vorrichtung nach einem der Ansprüche 7 bis 9, **dadurch gekennzeichnet, dass** sie eine Steuereinheit (39) umfasst, die angepasst ist, mindestens eine solche Umkehrvorrichtung (29, 35, 36) steuern zu können:
- im Direktmodus, wenn Kühlbedarfskriterien erfüllt sind,
- im Umkehrmodus, wenn die Kühlbedarfskriterien nicht erfüllt sind.

11. Vorrichtung nach Anspruch 10, **dadurch gekennzeichnet, dass** die Kühlbedarfskriterien mindestens ein Kriterium, so genanntes Temperaturkriterium, umfassen, wonach die Temperatur mindestens einer heißen Last (12) höher ist als eine zulässige Höchsttemperatur, und dadurch, dass die Steuereinheit (39) angepasst ist zum:
- Empfangen von Temperaturmesssignalen jeder heißen Last, für die mindestens ein Temperaturkriterium definiert ist,
- Prüfen, ob jedes Temperaturkriterium erfüllt ist,
- Steuern mindestens einer solchen Umkehrvorrichtung (29, 35, 36):
∘ im Direktmodus, wenn die gemessene Temperatur jeder heißen Last (12) jedes Temperaturkriterium erfüllt,
∘ im Umkehrmodus mindestens, wenn die gemessene Temperatur jeder heißen Last (12) nicht jedes Temperaturkriterium erfüllt.

12. Vorrichtung nach einem der Ansprüche 7 bis 11, **dadurch gekennzeichnet, dass** für jeden ersten Wärmetauscher (11) einer ersten Wärmetauschvorrichtung, die einer heißen Last (12) zugehörig ist, ein einzelner dritter Wärmetauscher (24) angeordnet ist, um im Direktmodus einen Teil des heißen Kühlmitteldurchsatzes, der aus diesem ersten Wärmetauscher (11) stammt, empfangen zu können.

13. Vorrichtung nach einem der Ansprüche 7 bis 12, **dadurch gekennzeichnet, dass** eine gesteuerte Umkehrvorrichtung (29, 35, 36) mindestens eines solchen dritten Wärmetauschers ein gesteuertes Drei-Wege-Ventil (29) umfasst, das aufweist:
- einen Ausgang, der mit einer Leitung (18) stromabwärts von mindestens einem ersten Wärmetauscher (11) verbunden ist,
- einen Eingang, der mit einer Leitung (19) verbunden ist, die mit einem zweiten Wärmetauscher (20) verbunden ist,
- einen Eingang/Ausgang, der mit einer ersten Mündung (27) des dritten Wärmetauschers (24) verbunden ist,
und dadurch, dass die Steuereinheit (39) mit dem Drei-Wege-Ventil (29) verbunden und angepasst ist, um:
- im Direktmodus den Eingang des Drei-Wege-Ventils (29) mit seinem Eingang/Ausgang zu verbinden, der als Ausgang für einen Durchsatz des Kühlmittels fungiert, das von der Eintrittsleitung (19) des zweiten Wärmetauschers (20) entnommen wird,
- im Umkehrmodus den Eingang/Ausgang des Drei-Wege-Ventils (29) mit seinem Ausgang zu verbinden, wobei der Eingang/Ausgang als Eingang für einen Durchsatz des Kühlmittels fungiert, das aus dem dritten Wärmetauscher (24) stammt, wobei das Kühlmittel, das aus dem Ausgang des Drei-Wege-Ventils (29) stammt, mit dem Kühlmittel der Austrittsleitung (18) gemischt wird.

14. Vorrichtung nach einem der Ansprüche 7 bis 13, **dadurch gekennzeichnet, dass** der dritte Wärmetauscher (24) eine zweite Mündung (30) umfasst, die verbunden ist:
- im Direktmodus mit einer Austrittsleitung (23) mindestens eines zweiten Wärmetauschers (20), wobei das Kühlmittel, das aus dieser zweiten Mündung (30) des dritten Wärmetauschers (24) stammt, mit dem Kühlmittel dieser Austrittsleitung (23) gemischt wird,
- im Umkehrmodus mit einer Expansionsvorrichtung (35) eines Durchsatzes des Kühlmittels.

15. Vorrichtung nach einem der Ansprüche 7 bis 14, **dadurch gekennzeichnet, dass** jeder Wärmespeicher (25), der einer dritten Wärmetauschvorrichtung zugehörig ist, ausgewählt wird aus der Gruppe, gebildet von Flüssigkeitstanks, Gastanks, Phasenänderungsmitteltanks, Festkörpern und ihren Kombinationen.

16. Fahrzeug, **dadurch gekennzeichnet, dass** es eine Vorrichtung nach einem der Ansprüche 7 bis 15 zum Kühlen mindestens einer heißen Last (12) an Bord des Fahrzeugs umfasst.

## Claims

1. Method for cooling at least one hot load on board a vehicle such as an aircraft including a heat-transfer fluid circulation fluid loop, wherein:
- for each hot load (12) to be cooled, a flow of said heat-transfer fluid, referred to as cold heat-transfer fluid flow, is introduced into a heat exchanger, referred to as first heat exchanger (11), of a first heat exchange device associated with the hot load (12) so as to transfer calories therefrom to the heat-transfer fluid, cool the hot load and produce a flow of said heat-transfer fluid, referred to as hot heat-transfer fluid flow, at a temperature greater than that of said cold heat-transfer fluid flow,
- at least a portion of said hot heat-transfer fluid flow from at least one such first heat exchanger (11) is introduced into at least one heat exchanger, referred to as second heat exchanger (20), of a second heat exchange device arranged to be able to cool same with air outside the vehicle,
- a flow of said heat-transfer fluid is introduced into at least one heat exchanger, referred to as third heat exchanger (24), of a third heat exchange device arranged to be able to exchange a heat flux between this flow of said heat-transfer fluid and at least one thermal store (25), separate from said heat-transfer fluid, on board the vehicle,
- when cooling requirement criteria are met, at least one such third heat exchanger (24) is fed according to a circulation mode, referred to as direct mode, wherein it receives, on a first orifice (27) of this third heat exchanger (24), at least a portion of said hot heat-transfer fluid flow from at least one such first heat exchanger (11), said corresponding third heat exchange device transferring calories from this hot heat-transfer fluid to the thermal store (25) so as to cool said heat-transfer fluid, the heat-transfer fluid thus cooled being delivered by a second orifice (30) of the third heat exchanger (24),
**characterised by** the step, wherein:
- when said cooling requirement criteria are not met, at least one such third heat exchanger (24) is fed according to a circulation mode, referred to as reverse mode, wherein it receives, on said second orifice (30) of this third heat exchanger (24), a flow of said heat-transfer fluid and said corresponding third heat exchange device transfers calories from the thermal store (25) to this heat-transfer fluid so as to cool this thermal store (25), and the heat-transfer fluid thus heated comes out of this third heat exchanger (24) via said first orifice (27) of this third heat exchanger (24) and wherein the fluid loop is a diphasic loop.

2. Method according to claim 1 **characterised in that** in reverse mode the heat-transfer fluid flow heated by this third heat exchanger (24) is mixed with the heat-transfer fluid flow heated by a first heat exchanger (11) .

3. Method according to any one of claims 1 to 2 **characterised in that** in reverse mode the second orifice of this third heat exchanger (24) receives at least a portion of a cold heat-transfer fluid flow of which another portion forms said cold heat-transfer fluid flow introduced into a first heat exchanger.

4. Method according to any one of claims 1 to 3 **characterised in that** in reverse mode this third heat exchanger (24) receives on the second orifice (30) thereof a heat-transfer fluid flow, referred to as cooled heat-transfer fluid flow, from a heat-transfer fluid tank (13) via a release device (35).

5. Method according to any one of claims 1 to 4 **characterised in that**:
- said cooling requirement criteria comprise at least one criterion, referred to as temperature criterion, whereby the temperature of at least one hot load (12) is greater than a maximum allowable temperature,
- the temperature of each hot load (12) for which at least one temperature criterion is defined is measured,
- at least one such heat exchanger (24) is fed:
∘ in direct mode when the temperature measured of each hot load (12) meets each temperature criterion,
∘ in reverse mode at least when the temperature measured of each hot load (12) does not meet each temperature criterion.

6. Method according to one of claims 1 to 5 **characterised in that** each thermal store (25) associated with a third heat exchange device is selected from the group formed of liquid tanks, gas tanks, phase-change material tanks, solid parts, and combinations thereof.

7. Device for cooling at least one hot load on board a vehicle such as an aircraft including a heat-transfer fluid circulation fluid loop comprising:
- for each hot load (12) to be cooled, a first heat exchange device associated with the hot load (12) so as to be able to transfer calories therefrom to a flow of said heat-transfer fluid, referred to as cold heat-transfer fluid flow, introduced into a heat exchanger, referred to as first heat exchanger (11), of this first heat exchange device, cool the hot load (12) and produce a flow of said heat-transfer fluid, referred to as hot heat-transfer fluid flow, at a temperature greater than that of said cold heat-transfer fluid flow,
- at least a second heat exchange device arranged to be able to cool with air outside the vehicle at least a portion of said hot heat-transfer fluid flow from at least a first heat exchanger (11) and introduced into a heat exchanger, referred to as second heat exchanger (20) of this second heat exchanger device,
- at least a third heat exchange device arranged to be able to exchange a heat flux between at least one thermal store (25), separate from said heat-transfer fluid, on board the vehicle and a flow of said heat-transfer fluid introduced into a heat exchanger, referred to as third heat exchanger (24) of this third heat exchange device,
- for each third heat exchanger (24), a circuit, referred to as inversion circuit, comprising a controlled inversion device (29, 35, 36) including at least one controlled valve, said inversion circuit and the controlled inversion device being arranged to be able to circulate said heat-transfer fluid in the third heat exchanger (24) according to a circulation mode selected from:
∘ a direct mode, wherein the third heat exchanger (24) receives, on a first orifice (27) of this third heat exchanger (24), at least a portion of said hot heat-transfer fluid flow from at least a first heat exchanger (11) and the third heat exchange device transfers calories from this hot heat-transfer fluid to the thermal store (25) so as to cool this heat-transfer fluid, the heat-transfer fluid thus cooled being delivered by a second orifice (30) of the third heat exchanger (24), **characterised by**:
∘ a reverse mode wherein the third heat exchanger (24) receives, on the second orifice (30) of this third heat exchanger (24), a flow of said heat-transfer fluid and the corresponding third heat exchange device transfers calories from the thermal store (25) to this heat-transfer fluid so as to cool this thermal store (25), the heat-transfer fluid thus heated coming out of this third heat exchanger (24) via said first orifice (27) of this third heat exchanger (24) and wherein the fluid loop is a diphasic loop.

8. Device according to claim 7 **characterised in that** in reverse mode the first orifice (27) of this third heat exchanger (24) is connected to a pipe (18) connected to the outlet of the first heat exchanger so as to mix the heat-transfer fluid flow heated by the third heat exchanger (24) with the heat-transfer fluid flow heated by this first heat exchanger (11).

9. Device according to any one of claims 7 to 8 **characterised in that** it includes a heat-transfer fluid tank (13) and at least one release device (35) inserted between the heat-transfer fluid tank and such a third heat exchanger (24) and arranged to deliver, in reverse mode, to this third heat exchanger (24) a heat-transfer fluid flow, referred to as cooled heat-transfer fluid flow, at a temperature less than that of each thermal store (25) associated with this third heat exchanger.

10. Device according to one of claims 7 to 9, **characterised in that** it includes a control unit (39) adapted to be able to control at least one such inversion device (29, 35, 36):
- in direct mode when cooling requirement criteria are met,
- in reverse mode when said cooling requirement criteria are not met.

11. Device according to claim 10 **characterised in that** said cooling requirement criteria comprise at least one criterion, referred to as temperature criterion, whereby the temperature of at least one hot load (12) is greater than a maximum allowable temperature, and **in that** the control unit (39) is adapted to:
- receive temperature measurement signals of each hot load for which at least one temperature criterion is defined,
- check whether each temperature criterion is met,
- control at least one such inversion device (29, 35, 36) :
∘ in direct mode when the temperature measured of each hot load (12) meets each temperature criterion,
∘ in reverse mode at least when the temperature measured of each hot load (12) does not meet each temperature criterion.

12. Device according to any one of claims 7 to 11 **characterised in that** for each first heat exchanger (11) of a first heat exchange device associated with a hot load (12), a single third heat exchanger (24) is arranged to be able to receive, in direct mode, a portion of the hot heat-transfer fluid flow from this first heat exchanger (11).

13. Device according to any one of claims 7 to 12 **characterised in that** a controlled inversion device (29, 35, 36) of at least one such third heat exchanger includes a controlled three-way valve (29) having:
- an outlet connected to a pipe (18) downstream from at least a first heat exchanger (11),
- an inlet connected to a pipe (19) connected to a second heat exchanger (20),
- an inlet/outlet connected to a first orifice (27) of the third heat exchanger (24),
and **in that** the control unit (39) is connected to the three-way valve (29) and adapted to:
- in direct mode connect the inlet of the three-way valve (29) to the inlet/outlet thereof which acts as an outlet for a flow of said heat-transfer fluid extracted from the inlet pipe (19) of the second heat exchanger (20),
- in reverse mode connect the inlet/outlet of the three-way valve (29) to the outlet thereof, the inlet/outlet acting as an inlet for a flow of said heat-transfer fluid from the third heat exchanger (24), said heat-transfer fluid from the outlet of the three-way valve (29) being mixed with said heat-transfer fluid of said outlet pipe (18).

14. Device according to one of claims 7 to 13 **characterised in that** the third exchanger (24) includes a second orifice (30) connected:
- in direct mode to an outlet pipe (23) of at least a second heat exchanger (20), said heat-transfer fluid from this second orifice (30) of the third exchanger (24) being mixed with said heat-transfer fluid of this outlet pipe (23),
- in reverse mode to a release device (35) of a flow of said heat-transfer fluid.

15. Device according to one of claims 7 to 14 **characterised in that** each thermal store (25) associated with a third heat exchange device is selected from the group formed of liquid tanks, gas tanks, phase-change material tanks, solid parts, and combinations thereof.

16. Vehicle **characterised in that** it comprises a device according to one of claims 7 to 15 for cooling at least one hot load (12) on board the vehicle.
